# EUROPEAN PATENT APPLICATION

(11) **EP 4 730 966 A1**
(43) Date of publication of application: **22.04.2026**
(21) Application number: 25207142.8
(22) Date of filing: 07.10.2025
(51) Int. Cl.: H10K 50/16, H10K 50/115

(54) **METAL OXIDE COMPOSITION, LIGHT-EMITTING DEVICE PRODUCED USING THE METAL OXIDE COMPOSITION, ELECTRONIC APPARATUS INCLUDING THE LIGHT-EMITTING DEVICE, AND ELECTRONIC DEVICE INCLUDING THE LIGHT-EMITTING DEVICE**

(30) Priority: 16.10.2024 KR 20240141445
(71) Applicant: Samsung Display Co., Ltd., Yongin-si, Gyeonggi-do 17113 (KR)
(72) Inventor: JO, Jungho, 17113 Yongin-si (KR); KIM, Heunggyu, 17113 Yongin-si (KR); PARK, Myoungjin, 17113 Yongin-si (KR); YU, Chungman, 17113 Yongin-si (KR); JUNG, Yunku, 17113 Yongin-si (KR)
(74) Representative: Marks & Clerk LLP

(57) **Abstract**

A metal oxide composition, a light-emitting device produced by using the metal oxide composition, an electronic apparatus including the light-emitting device, and an electronic device including the light-emitting device are disclosed. The metal oxide composition includes a metal oxide nanoparticle, a metal halide, and a solvent, wherein an amount of an organic material on the surface of the metal oxide nanoparticle is in a range of about 12 wt% to about 21 wt% based on the weight (e.g., based on 100 wt%) of the metal oxide nanoparticle, and an amount of the metal halide is greater than 0 wt% but not more than about 7.0 wt% based on the weight (e.g., based on 100 wt%) of the metal oxide nanoparticle.

## Description

### BACKGROUND

### 1. Field

One or more embodiments of the present disclosure relate to a metal oxide composition, a light-emitting device formed or provided by using the metal oxide composition, an electronic apparatus including the light-emitting device, and an electronic device including the light-emitting device.

### 2. Description of the Related Art

Light-emitting devices are self-emissive devices that, as compared with devices of the related art, have wide viewing angles, high contrast ratios, short response times, and excellent or suitable characteristics in terms of luminance, driving voltage, and response speed, and produce full-color images.

In a light-emitting device, a first electrode is provided on a substrate, and a hole transport region, an emission layer, an electron transport region, and a second electrode are sequentially provided on the first electrode. Holes provided from the first electrode move toward the emission layer through the hole transport region, and electrons provided from the second electrode move toward the emission layer through the electron transport region. Carriers, such as holes and electrons, recombine in the emission layer to produce excitons. If (e.g., when) the excitons transition from an excited state to a ground state, light is emitted.

### SUMMARY

One or more aspects of embodiments of the present disclosure are directed toward a metal oxide composition having stability (e.g., physical stability and/or structural stability) and reduced defects in metal oxide nanoparticles, and a light-emitting device having improved or enhanced luminescence efficiency and lifespan, formed or provided from the metal oxide composition.

Additional aspects of embodiments will be set forth in part in the description which follows and, in part, will be apparent from the description or may be learned by practice of the presented embodiments of the disclosure.

According to one or more embodiments, the metal oxide composition includes:
a metal oxide nanoparticle,
a metal halide, and
a solvent, wherein
an amount of an organic material on the surface of the metal oxide nanoparticle is in a range of about 12 wt% to about 21 wt% based on the weight (e.g., based on 100 wt%) of the metal oxide nanoparticle, and
an amount of the metal halide is greater than 0 wt% but not more than about 7.0 wt% based on the weight (e.g., based on 100 wt%) of the metal oxide nanoparticle.

According to one or more embodiments, a light-emitting device includes a first electrode, a second electrode opposite to (e.g., facing) the first electrode, and an interlayer between the first electrode and the second electrode,
the interlayer includes an emission layer and an electron transport region between the emission layer and the second electrode, and
the electron transport region includes an electron transport layer formed or provided from the metal oxide composition.

According to one or more embodiments, an electronic apparatus includes the light-emitting device.

According to one or more embodiments, an electronic device includes the light-emitting device.

### BRIEF DESCRIPTION OF THE DRAWINGS

The above and other aspects and features of certain embodiments of the present disclosure will be more apparent from the following description taken in conjunction with the accompanying drawings, in which:
FIG. 1 is a conceptual diagram illustrating binding of a metal halide included in a metal oxide composition according to one or more embodiments to defect sites on the surface of a metal oxide nanoparticle;
FIG. 2 is a schematic cross-sectional view illustrating the structure of a light-emitting device according to one or more embodiments;
FIG. 3 is a schematic cross-sectional view illustrating the structure of an electronic apparatus according to one or more embodiments;
FIG. 4 is a schematic cross-sectional view illustrating the structure of an electronic apparatus according to one or more embodiments;
FIG. 5 is a schematic perspective view illustrating an electronic device including a light-emitting device according to one or more embodiments;
FIG. 6 is a schematic perspective view of the exterior of a vehicle as an electronic device including a light-emitting device according to one or more embodiments; and
FIGS. 7A-7C are schematic interior views illustrating the interior of a vehicle according to one or more embodiments.

### DETAILED DESCRIPTION

As the present disclosure may apply one or more suitable transformations and may have one or more embodiments, certain embodiments will be illustrated in the accompanying drawings and described in more detail in the detailed description. Aspects and features of embodiments of the present disclosure and methods of achieving substantially the same will be clarified by referring to one or more embodiments described in more detail herein with reference to the drawings. However, embodiments of the present disclosure are not limited to the embodiments disclosed below and may be implemented in one or more suitable forms.

Hereinafter, the subject matter of the present disclosure will be described in more detail with reference to the accompanying drawings. Substantially the same or corresponding components will be denoted by the same reference numerals, and thus redundant description thereof may not be provided.

As used herein, the singular forms "a," "an," and "the" are intended to include the plural forms as well, unless the context clearly indicates otherwise.

The singular forms as used herein are intended to include the plural forms as well unless the context clearly indicates otherwise.

The term "and/or" shall include the combination of a plurality of listed items or any of the plurality of listed items.

As used herein, the terms "substantially," "about," and similar terms are used as terms of approximation and not as terms of degree and are intended to account for the inherent deviations in measured or calculated values that would be recognized by those of ordinary skill in the art.

The use of "may" if (e.g., when) describing embodiments of the present disclosure refers to "one or more embodiments of the present disclosure."

As used herein, the terms "use," "using," and "used" may be considered synonymous with the terms "utilize," "utilizing," and "utilized," respectively.

It will be further understood that the terms "has," "having," "comprises," and/or "comprising" used herein specify the presence of stated features or components, but do not preclude the presence or addition of one or more other features or components. For example, it should be understood that the terms "comprise(s)/comprising," "include(s)/including," or "have/has/having" specify the presence of stated features, integers, steps, operations, elements, and/or components, but do not preclude the presence or addition of one or more other features, integers, steps, operations, elements, components, and/or groups thereof. Additionally, the terms "comprise(s)/comprising," "include(s)/including," "have/has/having" or similar terms include or support the terms "consisting of" and "consisting essentially of," indicating the presence of stated features, integers, steps, operations, elements, and/or components, without or essentially without the presence of other features, integers, steps, operations, elements, components, and/or groups thereof.

Any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, for example, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in the present disclosure is intended to include all higher numerical limitations subsumed therein.

As utilized herein, the term "about" or similar terms are used as terms of approximation and not as terms of degree and are intended to account for the inherent deviations in measured or calculated values that would be recognized by those of ordinary skill in the art. The term "about" or "approximately," as used herein, is also inclusive of the stated value and refers to within an acceptable range of deviation for the particular value as determined by one of ordinary skill in the art, considering the measurement in question and the error associated with measurement of the particular quantity (e.g., the limitations of the measurement system). For example, "about" may refer to within one or more standard deviations, or within ±30%, ±20%, ±10%, or ±5% of the stated value.

It will be understood that if (e.g., when) a layer, a region, or a component is referred to as being "on" or "onto" another layer, region, or component, it may be directly or indirectly on the other layer, region, or component. For example, intervening layers, regions, or components may be present therebetween. In contrast, if (e.g., when) a layer, a region, or a component is referred to as being "directly on" another layer, region, or component, there may be no intervening layers, regions, or components present therebetween.

The sizes of elements in the drawings may be exaggerated to effectively or suitably illustrate the technical contents of the present disclosure. For example, because the sizes and thicknesses of components in the drawings may be arbitrarily illustrated for convenience of explanation, the following embodiments are not limited thereto.

The x-axis, the y-axis, and the z-axis are not limited to three axes of the rectangular coordinate system and may be interpreted in a broader sense. For example, the x-axis, the y-axis, and the z-axis may be perpendicular (e.g., substantially perpendicular) to one another or may represent different directions that are not perpendicular to one another.

It will be understood that, although the terms "first," "second," "third," and/or the like may be used herein to describe one or more elements, components, regions, layers, and/or sections, these elements, components, regions, layers, and/or sections should not be limited by these terms. These terms are used to distinguish one element, component, region, layer, or section from another element, component, region, layer, or section. Thus, a first element, a first component, a first region, a first layer, or a first section as described herein may be termed a second element, a second component, a second region, a second layer, or a second section, without departing from the scope of the present disclosure.

Unless otherwise defined, all terms, including technical terms and scientific terms, used herein have substantially the same meaning as how they are generally understood by those of ordinary skill in the art to which the present disclosure pertains. Any term that is defined in a general dictionary shall be construed to have substantially the same meaning in the context of the relevant art and, unless otherwise defined explicitly, shall not be interpreted to have an idealistic or excessively formalistic meaning.

### Composition

A metal oxide composition according to one or more embodiments includes:
a metal oxide nanoparticle;
a metal halide; and
a solvent.

According to one or more embodiments, the metal oxide nanoparticle may be represented by Formula 1:

Formula 1 M¹₁₋ₓM²ₓO_{y}

wherein, in Formula 1,
M¹ and M² each independently include zinc (Zn), magnesium (Mg), cobalt (Co), manganese (Mn), yttrium (Y), Ytterbium(Yb), aluminium (Al), titanium (Ti), zirconium (Zr), tin (Sn), tungsten (W), tantalum (Ta), nickel (Ni), molybdenum (Mo), copper (Cu), silver (Ag), indium (In), niobium (Nb), iron (Fe), cerium (Ce), strontium (Sr), barium (Ba), silicon (Si), gallium (Ga), or a combination thereof, and
0≤x≤1, and 0<y≤5.

In one or more embodiments, M¹ may be Zn, and 0≤x≤0.5.

In one or more embodiments, M¹ may be Zn, M² may be Mg, and 0<x≤0.5.

The metal oxide nanoparticle may include, for example, ZnO, TiO₂, ZrO₂, SnO₂, WO₃, W₂O₃, WO₂, Ta₂O₅, NiO, MoO₂, MoO₃, CuO, Cu₂O, Mg doped ZnO (ZnMgO), Co doped ZnO (ZnCoO), Mn doped ZnO (ZnMnO), Sn doped ZnO (ZnSnO), Al doped ZnO (ZnAlO), Si doped ZnO (ZnSiO), Yb doped ZnO (ZnYbO), or any combination thereof.

According to one or more embodiments, the average diameter (D50) of the metal oxide nanoparticle may be in a range of about 1 nm to about 50 nm. The average diameter of the metal oxide may be an average diameter measured by using a dynamic light scattering (DLS) method.

For example, the shape of the metal oxide nanoparticle may be spherical, for example, substantially spherical.

In one or more embodiments, the amount of the metal oxide nanoparticle may be in a range of about 0.5 wt% to about 10 wt% based on the total weight (e.g., based on 100 wt%) of the metal oxide composition.

According to one or more embodiments, the metal halide may be represented by Formula 2:

Formula 2 M³(X¹)z

wherein, in Formula 2,
M³ is an alkali metal, an alkaline earth metal, or a transition metal,
X¹ is fluorine (F), chlorine (CI), bromine (Br), or iodine (I), and
z is an integer of 1 to 3.

In one or more embodiments, M³ may include lithium (Li), sodium (Na), potassium (K), rubidium (Rb), cesium (Cs), Zn, In, Ti, Mg, Ga, or any combination thereof.

In one or more embodiments, the metal halide may include LiF, NaF, KF, RbF, CsF, LiCl, NaCl, KCI, RbCl, CsCl, LiBr, NaBr, KBr, RbBr, CsBr, Lil, Nal, KI, Rbl, Csl, ZnCl₂, ZnBr₂, Znl₂, MgCl₂, MgBr₂, Mgl₂, GaCl₂, GaBr₂, GaI₂, or any combination thereof.

The metal halide may include, for example, LiCl, LiBr, ZnCl₂, ZnBr₂, ZnI₂, MgCl₂, GaCl₂, or any combination thereof.

The amount of the metal halide is in a range of greater than 0 wt% but not more than about 7 wt% based on the weight (e.g., based on 100 wt%) of the metal oxide nanoparticle. The amount of the metal halide may be, for example, about 0.1 wt% to about 7 wt%, about 1 wt% to about 7 wt% or about 2 wt% to about 5 wt%, based on the weight (e.g., based on 100 wt%) of the metal oxide nanoparticle. In one or more embodiments, the amount of the metal halide may be in a range of greater than 0 wt% to less than about 7 wt% based on the weight (e.g., based on 100 wt%) of the metal oxide nanoparticle. For example, the amount of the metal halide may be, for example, about 0.1 wt% to less than 7 wt%, or about 0.1 wt% to about 6.9 wt% based on the weight (e.g., based on 100 wt%) of the metal oxide nanoparticle.

In one or more embodiments, an organic material is attached on the surface of the metal oxide nanoparticle. The organic material may be an organic compound derived from a reaction byproduct generated during the synthesis process for the metal oxide nanoparticle. In one or more embodiments, the organic material may include both (e.g., simultaneously) a reaction byproduct and an organic ligand. The total amount of the organic material is in a range of about 12 wt% to about 21 wt% based on the weight (e.g., based on 100 wt%) of the metal oxide nanoparticle.

The metal oxide nanoparticle may have defects, such as oxygen vacancies and dangling bonds, on the surface thereof, which may cause exciton quenching of the light-emitting device and reduce the efficiency and lifespan of the light-emitting device. In one or more embodiments, in the process of forming or providing an electron transport layer from a metal oxide composition on an emission layer, the ligand on the surface of the quantum dot of the emission layer may be desorbed due to a solvent of the metal oxide composition and/or the like, and defects may also occur on the surface of the quantum dot of the emission layer. These defects on the surface of a quantum dot may also cause exciton quenching in light-emitting devices, reducing their efficiency and lifespan.

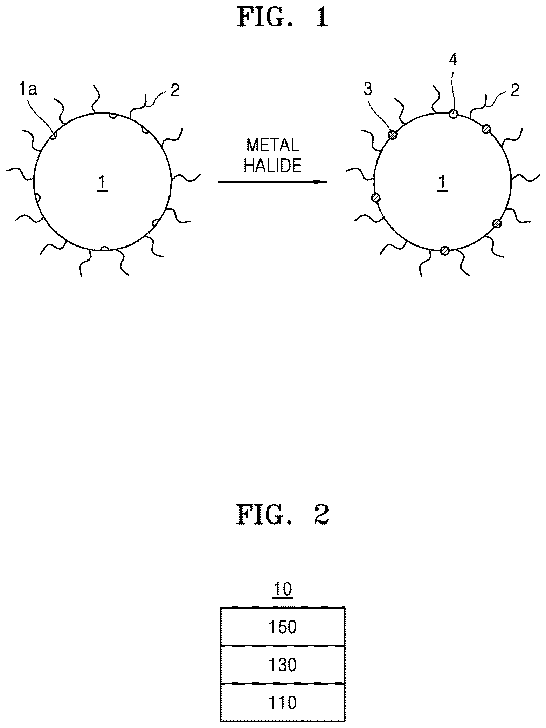

The metal halide in the metal oxide composition according to one or more embodiments of the present disclosure may bind to defect sites of the metal oxide nanoparticle to remove the defects. FIG. 1 is a conceptual diagram illustrating binding of a metal halide included in a metal oxide composition according to one or more embodiments to defect sites on the surface of a metal oxide nanoparticle. Referring to FIG. 1, defect sites 1a may be formed or generated on the surface of a metal oxide nanoparticle 1 and an organic material 2 may be attached to the surface of a metal oxide nanoparticle 1. The organic material 2 may be a reaction byproduct or may be a reaction byproduct and an organic ligand. The metal halide included in the metal oxide composition may be separated into a metal ion 3 and a halogen ion 4, each of which may be bonded to the defect sites 1a on the surface of the metal oxide nanoparticle 1. In one or more embodiments, the metal halide may fill in the defects of the metal oxide nanoparticle, thereby reducing and/or preventing exciton quenching of the light-emitting device and deterioration of the efficiency and lifespan of the light-emitting device.

It is desirable that the metal halide is readily accessible to the surface of the metal oxide nanoparticle in order to bind to defect sites on the surface of the metal oxide nanoparticle as described in one or more embodiments. If (e.g., when) the amount of an organic material on the surface of metal oxide nanoparticle is high, access of the metal halide may be difficult. If (e.g., when) the amount of the organic material is in a range of about 12 wt% to about 21 wt% based on the weight (e.g., based on 100 wt%) of the metal oxide nanoparticle, the metal halide in the metal oxide composition may effectively or suitably fill in the defects of the metal oxide nanoparticle.

After the synthesis of metal oxide nanoparticles, organic materials as reaction byproducts may remain on the surface of the metal oxide nanoparticle. A purification process for the metal oxide nanoparticle may be performed to remove the organic material and reduce the amount of the organic material on the surface to be within the foregoing range. The purification process for the metal oxide nanoparticle may be performed by repeating the process of adding an excessive amount of nonpolar solvent to a polar solvent dispersion of the metal oxide nanoparticle obtained by synthesis and separating by precipitation by utilizing a centrifuge.

Polar solvents used in the dispersion of the metal oxide nanoparticle may include, for example, methanol, ethanol, ethylene glycol, diethylene glycol, 2-aminoethanol, propanol, butanol, benzyl alcohol, ethyl acetone, and/or the like.

Nonpolar solvents that may be used for centrifugal separation of the metal oxide nanoparticle include, for example, cyclohexane, n-hexane, pentane, heptane, toluene, benzene, methyl acetate, and/or ethyl acetate.

The metal oxide composition includes a solvent. The solvent is not limited in type or kind as long as it may appropriately or suitably disperse the metal oxide nanoparticles and the metal halide.

For example, the solvent may be an organic solvent.

In one or more embodiments, the solvent may be selected from among an alcohol-based solvent, a chlorine-based solvent, an ether-based solvent, an ester-based solvent, a ketone-based solvent, an aliphatic hydrocarbon-based solvent, and an aromatic hydrocarbon-based organic solvent, but embodiments of the present disclosure are not limited thereto.

Examples of the solvent may be an ether alcohol solvent, such as 2-(2-tertbutoxyethoxy)ethanol, 2-(2-(isopentyloxy)ethoxy)ethanol, 2-(2-(2-tertbutoxyethoxy)ethoxy)ethanol, 2-(2-(2-isopropoxyethoxy)ethoxy)ethanol, 2-(2-(isopentyloxy)ethoxy)ethanol, 2-(2-(benzyloxy)ethoxy)ethanol, 2-(2-(2-(benzyloxy)ethoxy)ethoxy)ethanol, 2-((tetrahydrofuran-2-yl)methoxy)ethanol, and/or the like; an alcohol solvent, such as methanol, ethanol, n-propanol, iso-propanol, n-butanol, iso-butanol, sec-butanol, t-butanol, and/or the like; a chlorinated solvent, such as dichloromethane, 1,2-dichloroethane, 1,1,2-trichloroethane, chlorobenzene, o-dichlorobenzene, and/or the like; an ether solvent, such as tetrahydrofuran, dioxane, anisole, 4-methylanisole, butyl phenyl ether, and/or the like; an ester solvent, such as ethyl acetate, butyl acetate, methyl benzoate, ethyl benzoate, butyl benzoate, phenyl benzoate, and/or the like; a ketone solvent, such as acetone, methylethylketone, cyclohexanone, acetophenone, and/or the like; an aliphatic hydrocarbon solvent, such as cyclohexane, methylcyclohexane, n-pentane, n-hexane, n-heptane, n-octane, n-nonane, n-decane, dodecane, hexadecane, oxadecane, and/or the like; an aromatic hydrocarbon solvent, such as toluene, xylene, mesitylene, ethylbenzene, n-hexylbenzene, cyclohexylbenzene, trimethylbenzene, tetrahydronaphthalene, and/or the like; or any combination thereof, but embodiments of the present disclosure are not limited thereto.

The amount of the solvent in the metal oxide composition may be from (e.g., in a range of) about 80 wt% to about 99.5 wt%, for example, from (e.g., in a range of) about 90 wt% to about 99 wt%, based on the total weight (e.g., based on 100 wt%) of the metal oxide composition, but embodiments of the present disclosure are not limited thereto. If (e.g., when) the foregoing ranges are satisfied, the metal oxide nanoparticle and the metal halide may be appropriately or suitably dispersed in the metal oxide composition and may have a solid concentration suitable for a solution process.

The viscosity of the metal oxide composition may be from (e.g., in a range of) about 1 cP to about 30 cP. A metal oxide composition satisfying the viscosity range may be suitable for manufacturing a metal oxide layer of a light-emitting device by a solution process.

The surface tension of the metal oxide composition may be from (e.g., in a range of) about 10 dynes/cm to about 40 dynes/cm. A metal oxide composition satisfying the surface tension range may be suitable for manufacturing a metal oxide layer of a light-emitting device by a solution process.

### Method of manufacturing light-emitting device

A method of manufacturing a light-emitting device may include: forming or providing an emission layer including quantum dots on a first electrode;
forming or providing an electron transport layer by providing the metal oxide composition on the emission layer; and
forming or providing a second electrode on the electron transport layer.

According to one or more embodiments, the forming or providing of the emission layer may include applying a quantum dot composition including quantum dots and a solvent onto the first electrode; and removing the solvent.

After the quantum dot composition is provided on the first electrode, the solvent may be removed by vacuum and/or heat to form or provide an emission layer, but embodiments of the present disclosure are not limited thereto.

For example, the removing of the solvent may be performed at a set or predetermined temperature, for example, at about 50 °C to about 150 °C. For example, heat-treating may be performed under vacuum.

The quantum dot composition may be provided on the first electrode having a thickness of, for example, about 10 nm to about 100 nm.

According to one or more embodiments, the forming or providing of the electron transport layer may include applying the metal oxide composition on the emission layer, and removing the solvent.

After the metal oxide composition is provided on the emission layer, the solvent may be removed by vacuum and/or heat to form or provide an electron transport layer. However, embodiments of the present disclosure are not limited thereto.

For example, the removing of the solvent may be performed at a set or predetermined temperature, for example, at about 50 °C to about 150 °C. For example, heat-treating may be performed under vacuum.

The quantum dot composition and the metal oxide composition may be provided on the first electrode by using a solution process, but embodiments of the present disclosure are not limited thereto. The solution process may be, for example, an inkjet printing process, a drop casting process, a spin coating process, a dip coating process, a spray coating process, a flow coating process, and/or a screen printing process, but embodiments of the present disclosure are not limited thereto.

The solvent may include an organic solvent as described in one or more embodiments.

FIG. 2 schematically illustrates the structure of a light-emitting device 10 according to one or more embodiments. The light-emitting device 10 includes a first electrode 110, an interlayer 130, and a second electrode 150.

Hereinafter, the structure of the light-emitting device 10 according to one or more embodiments and a method of manufacturing the light-emitting device 10 will be described in more detail in connection with FIG. 2.

### First electrode 110

In FIG. 2, a substrate may be additionally arranged or provided under the first electrode 110 or above the second electrode 150. As the substrate, a glass substrate and/or a plastic substrate may be used. In one or more embodiments, the substrate may be a flexible substrate and may include plastics having excellent or suitable heat resistance and durability, such as polyimide, polyethylene terephthalate (PET), polycarbonate, polyethylene naphthalate, polyarylate (PAR), polyetherimide, or any combination thereof.

The first electrode 110 may be formed or provided by, for example, depositing and/or sputtering a material to form or provide the first electrode 110 on the substrate. If (e.g., when) the first electrode 110 is an anode, a material to form or provide the first electrode 110 may be a high-work function material that facilitates injection of holes.

The first electrode 110 may be a reflective electrode, a transflective electrode, or a transmissive electrode. If (e.g., when) the first electrode 110 is a transmissive electrode, a material to form or provide the first electrode 110 may include indium tin oxide (ITO), indium zinc oxide (IZO), tin oxide (e.g., SnO₂), zinc oxide (e.g., ZnO), or any combination thereof. In one or more embodiments, if (e.g., when) the first electrode 110 is a transflective electrode or a reflective electrode, a material to form or provide the first electrode 110 may include magnesium (Mg), silver (Ag), aluminium (Al), aluminium-lithium (Al-Li), calcium (Ca), magnesium-indium (Mg-In), magnesium-silver (Mg-Ag), or any combination thereof.

The first electrode 110 may have a single-layer structure consisting of (e.g., including) a single layer or a multilayer structure including a plurality of layers. In one or more embodiments, the first electrode 110 may have a three-layer structure of ITO/Ag/ITO.

### Interlayer 130

The interlayer 130 is disposed or provided on the first electrode 110. The interlayer 130 includes an emission layer.

The interlayer 130 may further include a hole transport region arranged or provided between the first electrode 110 and the emission layer, and includes an electron transport region arranged or provided between the emission layer and the second electrode 150.

The interlayer 130 may further include, in addition to one or more suitable organic materials, inorganic materials, such as metal-containing compounds and quantum dots.

In one or more embodiments, the interlayer 130 may include, i) two or more emitting units sequentially stacked between the first electrode 110 and the second electrode 150, and ii) a charge generation layer between adjacent emitting units among the two or more emitting units. If (e.g., when) the interlayer 130 includes emitting units and a charge generation layer as described in one or more embodiments, the light-emitting device 10 may be a tandem light-emitting device.

### Hole transport region in interlayer 130

The hole transport region may have: i) a single-layer structure consisting of (e.g., including) a single layer consisting of (e.g., including) a single material, ii) a single-layer structure consisting of (e.g., including) a single layer consisting of (e.g., including) a plurality of materials that are different from each other, or iii) a multilayer structure including a plurality of layers including a plurality of materials that are different from each other.

The hole transport region may include a hole injection layer, a hole transport layer, an emission auxiliary layer, an electron-blocking layer, or any combination thereof.

For example, the hole transport region may have a multi-layer structure including a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron-blocking layer structure, wherein layers in each structure are sequentially stacked from the first electrode 110.

The hole transport region may include a compound represented by Formula 201, a compound represented by Formula 202, or any combination thereof: 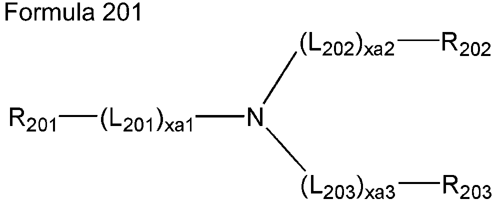 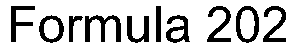 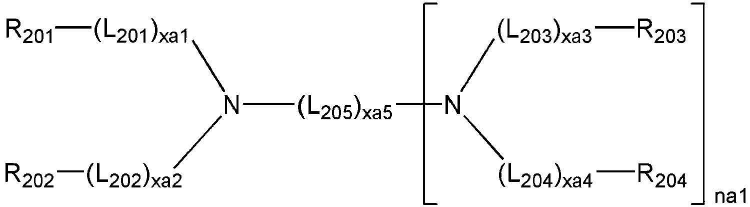 wherein, in Formulae 201 and 202,
L₂₀₁ to L₂₀₄ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
L₂₀₅ may be *-O-*', *-S-*', *-N(Q₂₀₁)-*', a C₁-C₂₀ alkylene group unsubstituted or substituted with at least one R₁₀ₐ, a C₂-C₂₀ alkenylene group unsubstituted or substituted with at least one R₁₀ₐ, a C₃-C₆₀ carbocyclic group unsubstituted or substituted with at least one R₁₀ₐ, or a C₁-C₆₀ heterocyclic group unsubstituted or substituted with at least one R₁₀ₐ,
xa1 to xa4 may each independently be an integer of 0 to 5,
xa5 may be an integer of 1 to 10,
R₂₀₁ to R₂₀₄ and Q₂₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
R₂₀₁ and R₂₀₂ may optionally be linked to each other via a single bond (e.g., a single covalent bond), a C₁-C₅ alkylene group unsubstituted or substituted with at least one R₁₀ₐ, or a C₂-C₅ alkenylene group unsubstituted or substituted with at least one R₁₀ₐ to form a C₈-C₆₀ polycyclic group (e.g., a carbazole group and/or the like) unsubstituted or substituted with at least one R₁₀ₐ (e.g., see Compound HT16),
R₂₀₃ and R₂₀₄ may optionally be linked to each other via a single bond (e.g., a single covalent bond), a C₁-C₅ alkylene group that is unsubstituted or substituted with at least one R₁₀ₐ, or a C₂-C₅ alkenylene group that is unsubstituted or substituted with at least one R₁₀ₐ to form a C₈-C₆₀ polycyclic group that is unsubstituted or substituted with at least one R₁₀ₐ, and
na1 may be an integer of 1 to 4.

In one or more embodiments, each of Formulae 201 and 202 may include at least one selected from among the groups represented by Formulae CY201 to CY217: 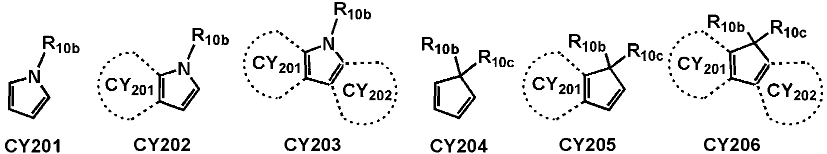 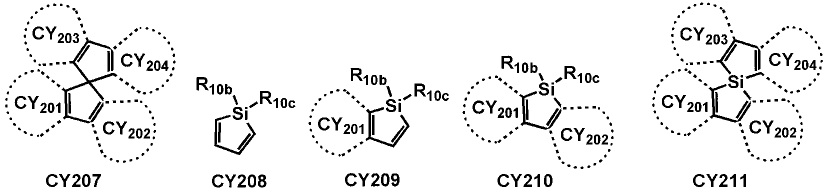 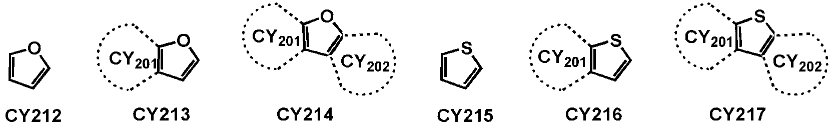 wherein, in Formulae CY201 to CY217, R_{10b}, and R_{10c} may each be the same as defined with respect to R₁₀ₐ, ring CY₂₀₁ to ring CY₂₀₄ may each independently be a C₃-C₂₀ carbocyclic group or a C₁-C₂₀ heterocyclic group, and at least one hydrogen in Formulae CY201 to CY217 may be unsubstituted or substituted with R₁₀ₐ.

In one or more embodiments, rings CY₂₀₁ to CY₂₀₄ in Formulae CY201 to CY217 may each independently be a benzene group, a naphthalene group, a phenanthrene group, or an anthracene group.

In one or more embodiments, each of Formulae 201 and 202 may include at least one selected from among the groups represented by Formulae CY201 to CY203.

In one or more embodiments, Formula 201 may include at least one selected from among the groups represented by Formulae CY201 to CY203 and at least one selected from among the groups represented by Formulae CY204 to CY217.

In one or more embodiments, in Formula 201, xa1 may be 1, R₂₀₁ may be a group represented by one selected from among Formulae CY201 to CY203, xa2 may be 0, and R₂₀₂ may be a group represented by one selected from among Formulae CY204 to CY207.

In one or more embodiments, each of Formulae 201 and 202 may not include groups represented by Formulae CY201 to CY203.

In one or more embodiments, each of Formulae 201 and 202 may not include groups represented by Formulae CY201 to CY203 and may include at least one selected from among the groups represented by Formulae CY204 to CY217.

In one or more embodiments, each of Formulae 201 and 202 may not include groups represented by Formulae CY201 to CY217.

For example, the hole transport region may include one selected from among Compounds HT1 to HT46, m-MTDATA, TDATA, 2-TNATA, NPB(NPD), β-NPB, TPD, spiro-TPD, spiro-NPB, methylated-NPB, TAPC, HMTPD, 4,4',4"-tris(N-carbazolyl)triphenylamine (TCTA), polyaniline/dodecylbenzenesulfonic acid (Pani/DBSA), poly(3,4-ethylenedioxythiophene)/poly(4-styrenesulfonate) (PEDOT/PSS), polyaniline/camphor sulfonic acid (Pani/CSA), polyaniline/poly(4-styrenesulfonate) (PANI/PSS), poly(9,9-dioctylfluorene-alt-N-(4-sec-butylphenyl)-diphenylamine (TFB), or any combination thereof:

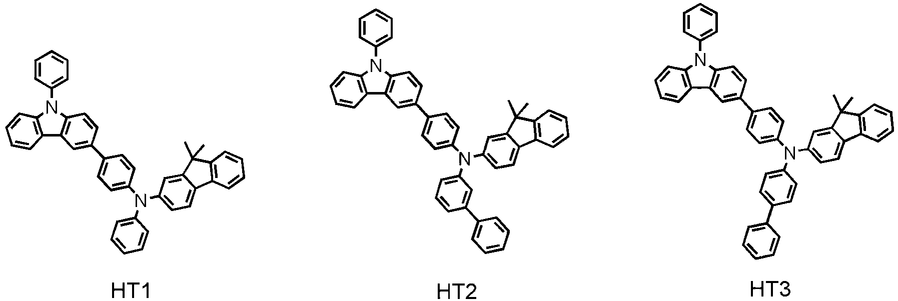

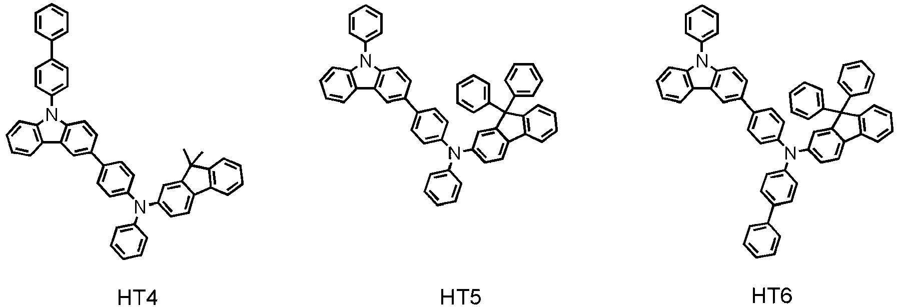

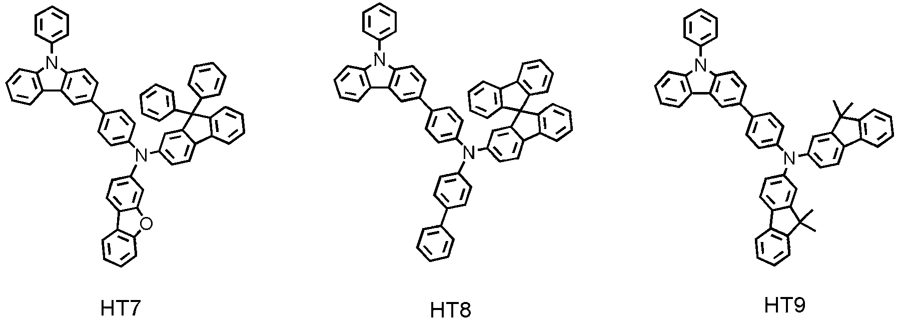

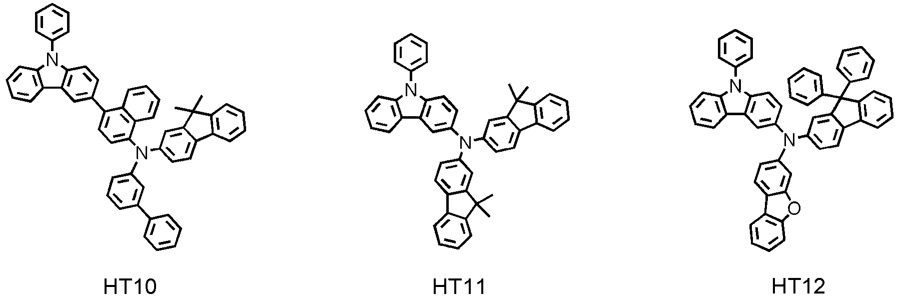

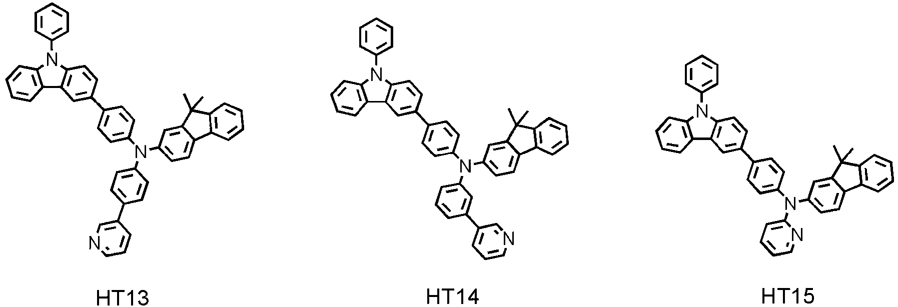

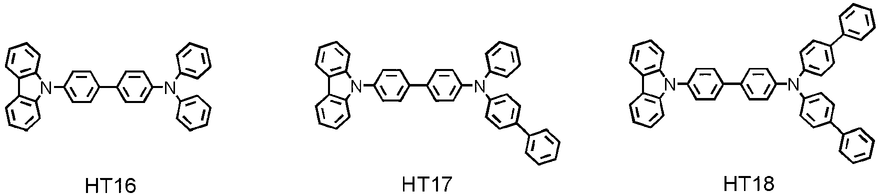

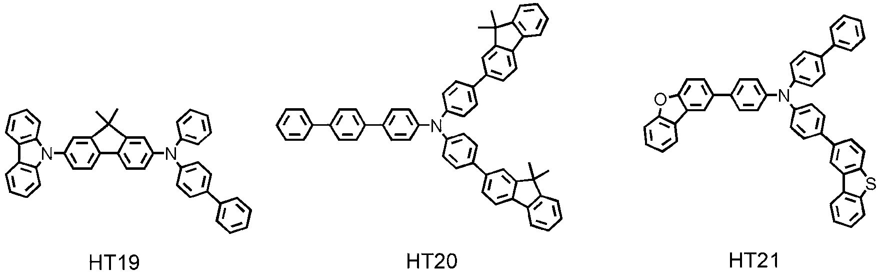

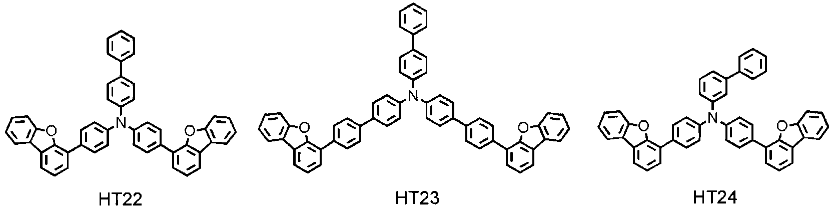

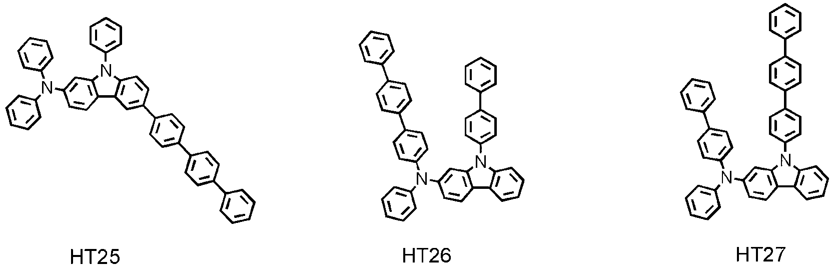

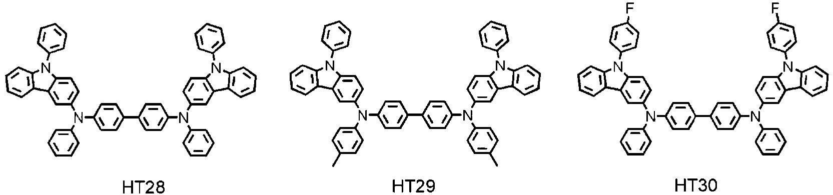

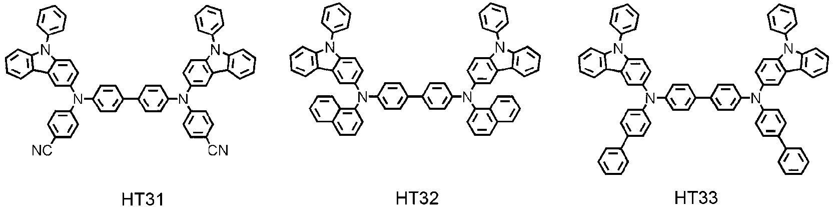

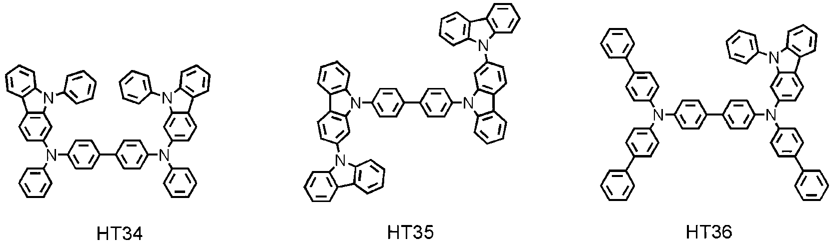

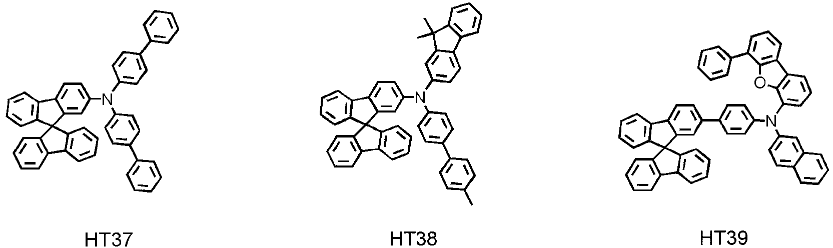

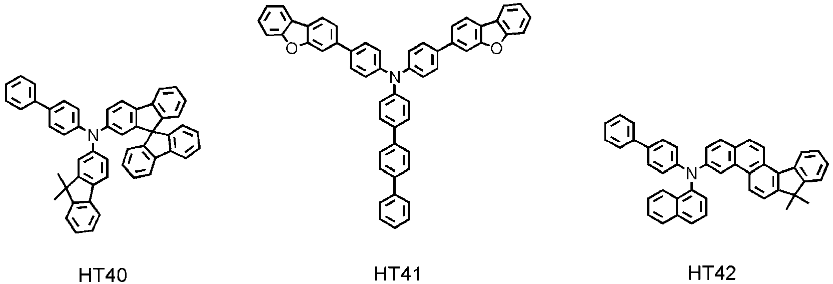

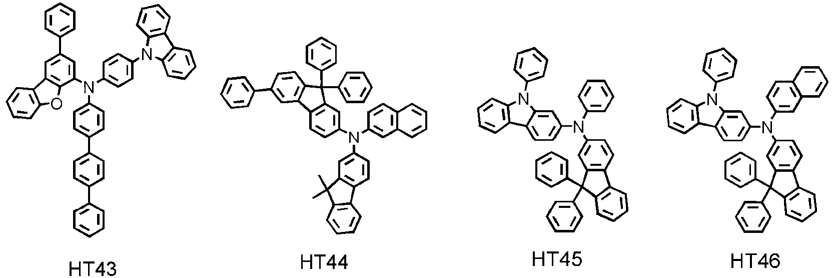

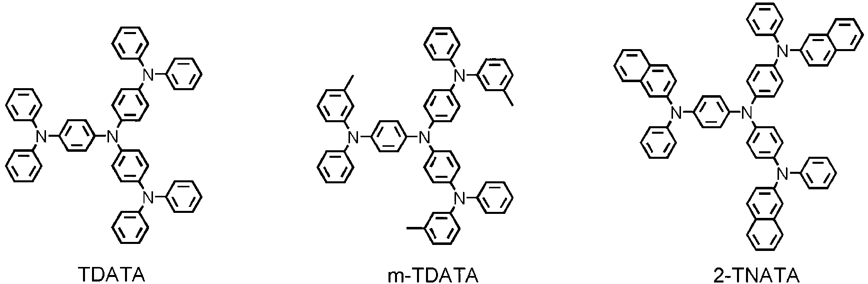

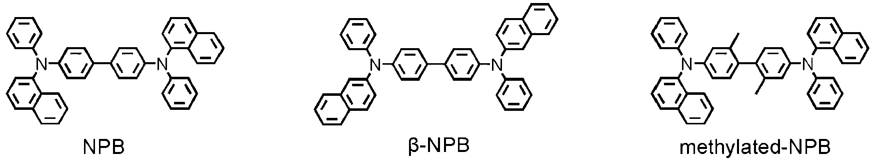

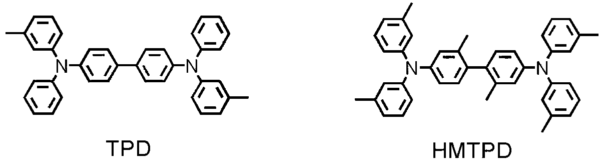

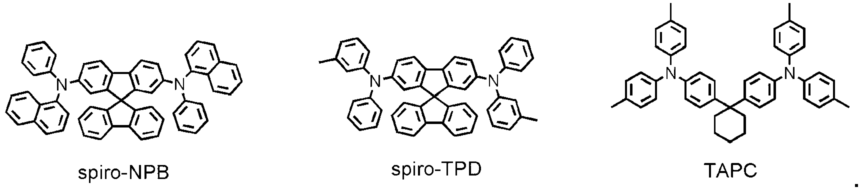

The thickness of the hole transport region may be from (e.g., in a range of) about 100 Å to about 10,000 Å, for example, from (e.g., in a range of) about 100 Å to about 4,000 Å. If (e.g., when) the hole transport region includes a hole injection layer, a hole transport layer, or any combination thereof, the thickness of the hole injection layer may be from (e.g., in a range of) about 100 Å to about 9,000 Å, for example, from (e.g., in a range of) about 100 Å to about 1,000 Å, and the thickness of the hole transport layer may be from (e.g., in a range of) about 50 Å to about 2,000 Å, for example, from (e.g., in a range of) about 100 Å to about 1,500 Å. If (e.g., when) the thicknesses of the hole transport region, the hole injection layer, and the hole transport layer are within the foregoing ranges, the desired or satisfactory hole transporting characteristics may be obtained without a substantial increase in driving voltage.

The emission auxiliary layer may increase or enhance luminescence efficiency by compensating for an optical resonance distance according to the wavelength of light emitted by the emission layer, and the electron-blocking layer may block the leakage of electrons from the emission layer to the hole transport region (or reduce a degree to or occurrence of which electrons leak from the emission layer to the hole transport region). Materials that may be included in the hole transport region may be included in the emission auxiliary layer and the electron-blocking layer.

### p-dopant

The hole transport region may further include, in addition to these materials as described in one or more embodiments, a charge-generation material for the enhancement of conductive (e.g., electrically conductive) properties. The charge-generation material may be uniformly (e.g., substantially uniformly) or non-uniformly (e.g., substantially non-uniformly) dispersed in the hole transport region (for example, in the form of a single layer consisting of (e.g., including) a charge-generation material).

The charge-generation material may be, for example, a p-dopant.

For example, the lowest unoccupied molecular orbital (LUMO) energy of the p-dopant may be not more than about -3.5 eV.

In one or more embodiments, the p-dopant may include a quinone derivative, a cyano group-containing compound, an element EL1 and an element EL2-containing compound, or any combination thereof.

Examples of the quinone derivative may include TCNQ and/or F4-TCNQ.

Examples of the cyano group-containing compound may include HAT-CN and a compound represented by Formula 221.

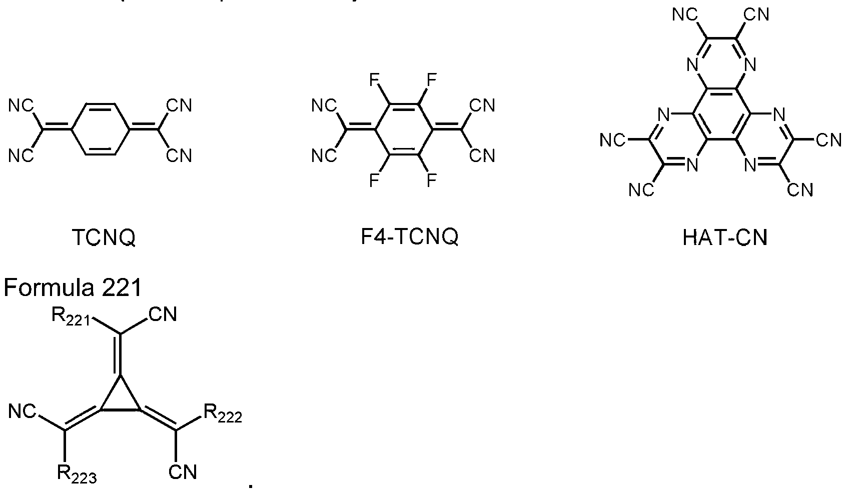

In Formula 221,
R₂₂₁ to R₂₂₃ may each independently be a C₃-C₆₀ carbocyclic group that is unsubstituted or substituted with at least one R₁₀ₐ or a C₁-C₆₀ heterocyclic group that is unsubstituted or substituted with at least one R₁₀ₐ, and
at least one selected from among R₂₂₁ to R₂₂₃ may each independently be a C₃-C₆₀ carbocyclic group or a C₁-C₆₀ heterocyclic group, each being unsubstituted or substituted with: a cyano group; -F; -Cl; -Br; -I; a C₁-C₂₀ alkyl group unsubstituted or substituted with a cyano group, -F, -Cl, -Br, -I, or any combination thereof; or any combination thereof.

In the compound including the element EL1 and the element EL2, the element EL1 may be a metal, a metalloid, or a combination thereof, and the element EL2 may be a non-metal, a metalloid, or a combination thereof.

An example of the metal may be an alkali metal (for example, lithium (Li), sodium (Na), potassium (K), rubidium (Rb), cesium (Cs), and/or the like); an alkaline earth metal (for example, beryllium (Be), magnesium (Mg), calcium (Ca), strontium (Sr), barium (Ba), and/or the like); a transition metal (for example, titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), and/or the like); a post-transition metal (for example, zinc (Zn), indium (In), tin (Sn), and/or the like); and a lanthanide metal (for example, lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), and/or the like).

Examples of the metalloid may be silicon (Si), antimony (Sb), and/or tellurium (Te).

Examples of the non-metal may be oxygen (O) and/or halogen (for example, F, Cl, Br, I, and/or the like).

Examples of the compound including the element EL1 and the element EL2 may be a metal oxide, a metal halide (for example, a metal fluoride, a metal chloride, a metal bromide, a metal iodide, and/or the like), a metalloid halide (for example, a metalloid fluoride, a metalloid chloride, a metalloid bromide, a metalloid iodide, and/or the like), a metal telluride, or any combination thereof.

Examples of the metal oxide may be a tungsten oxide (for example, WO, W₂O₃, WO₂, WO₃, W₂O₅, and/or the like), a vanadium oxide (for example, VO, V₂O₃, VO₂, V₂O₅, and/or the like), a molybdenum oxide (for example, MoO, Mo₂O₃, MoO₂, MoO₃, Mo₂O₅, and/or the like), and a rhenium oxide (for example, ReO₃ and/or the like).

Examples of the metal halide may be an alkali metal halide, an alkaline earth metal halide, a transition metal halide, a post-transition metal halide, and/or a lanthanide metal halide.

Examples of the alkali metal halide may be LiF, NaF, KF, RbF, CsF, LiCl, NaCl, KCI, RbCl, CsCl, LiBr, NaBr, KBr, RbBr, CsBr, Lil, Nal, KI, Rbl, and/or Csl.

Examples of the alkaline earth metal halide may be BeF₂, MgF₂, CaF₂, SrF₂, BaF₂, BeCl₂, MgCl₂, CaCl₂, SrCl₂, BaCl₂, BeBr₂, MgBr₂, CaBr₂, SrBr₂, BaBr₂, BeI₂, MgI₂, CaI₂, SrI₂, and/or BaI₂.

Examples of the transition metal halide may be a titanium halide (for example, TiF₄, TiCl₄, TiBr₄, TiI₄, and/or the like), a zirconium halide (for example, ZrF₄, ZrCl₄, ZrBr₄, ZrI₄, and/or the like), a hafnium halide (for example, HfF₄, HfCl₄, HfBr₄, HfI₄, and/or the like), a vanadium halide (for example, VF₃, VCl₃, VBr₃, VI₃, and/or the like), a niobium halide (for example, NbF₃, NbCl₃, NbBr₃, NbI₃, and/or the like), a tantalum halide (for example, TaF₃, TaCl₃, TaBr₃, TaI₃, and/or the like), a chromium halide (for example, CrF₃, CrCl₃, CrBr₃, CrI₃, and/or the like), a molybdenum halide (for example, MoF₃, MoCl₃, MoBr₃, MoI₃, and/or the like), a tungsten halide (for example, WF₃, WCl₃, WBr₃, WI₃, and/or the like), a manganese halide (for example, MnF₂, MnCl₂, MnBr₂, MnI₂, and/or the like), a technetium halide (for example, TcF₂, TcCl₂, TcBr₂, Tcl₂, and/or the like), a rhenium halide (for example, ReF₂, ReCl₂, ReBr₂, ReI₂, and/or the like), an iron halide (for example, FeF₂, FeCl₂, FeBr₂, FeI₂, and/or the like), a ruthenium halide (for example, RuF₂, RuCl₂, RuBr₂, RuI₂, and/or the like), an osmium halide (for example, OsF₂, OsCl₂, OsBr₂, OsI₂, and/or the like), a cobalt halide (for example, CoF₂, CoCl₂, CoBr₂, CoI₂, and/or the like), a rhodium halide (for example, RhF₂, RhCl₂, RhBr₂, RhI₂, and/or the like), an iridium halide (for example, IrF₂, IrCl₂, IrBr₂, IrI₂, and/or the like), a nickel halide (for example, NiF₂, NiCl₂, NiBr₂, NiI₂, and/or the like), a palladium halide (for example, PdF₂, PdCl₂, PdBr₂, PdI₂, and/or the like), a platinum halide (for example, PtF₂, PtCl₂, PtBr₂, PtI₂, and/or the like), a copper halide (for example, CuF, CuCl, CuBr, Cul, and/or the like), a silver halide (for example, AgF, AgCl, AgBr, Agl, and/or the like), and a gold halide (for example, AuF, AuCl, AuBr, Aul, and/or the like).

Examples of the post-transition metal halide may be a zinc halide (for example, ZnF₂, ZnCl₂, ZnBr₂, Znl₂, and/or the like), an indium halide (for example, InI₃ and/or the like), and a tin halide (for example, SnI₂ and/or the like).

Examples of the lanthanide metal halide may be YbF, YbF₂, YbF₃, SmF₃, YbCl, YbCl₂, YbCl₃, SmCl₃, YbBr, YbBr₂, YbBr₃, SmBr₃, Ybl, YbI₂, YbI₃, SmI₃, and/or the like.

Examples of the metalloid halide may be an antimony halide (for example, SbCl₅ and/or the like).

Examples of the metal telluride may be an alkali metal telluride (for example, Li₂Te, Na₂Te, K₂Te, Rb₂Te, Cs₂Te, and/or the like), an alkaline earth metal telluride (for example, BeTe, MgTe, CaTe, SrTe, BaTe, and/or the like), a transition metal telluride (for example, TiTe₂, ZrTe₂, HfTe₂, V₂Te₃, Nb₂Te₃, Ta₂Te₃, Cr₂Te₃, Mo₂Te₃, W₂Te₃, MnTe, TcTe, ReTe, FeTe, RuTe, OsTe, CoTe, RhTe, IrTe, NiTe, PdTe, PtTe, Cu₂Te, CuTe, Ag₂Te, AgTe, Au₂Te, and/or the like), a post-transition metal telluride (for example, ZnTe and/or the like), and a lanthanide metal telluride (for example, LaTe, CeTe, PrTe, NdTe, PmTe, EuTe, GdTe, TbTe, DyTe, HoTe, ErTe, TmTe, YbTe, LuTe, and/or the like).

### Emission layer in interlayer 130

If (e.g., when) the light-emitting device 10 is a full-color light-emitting device, the emission layer may be patterned into a red emission layer, a green emission layer, and/or a blue emission layer, according to a sub-pixel. In one or more embodiments, the emission layer may have a stacked structure of two or more layers of a red emission layer, a green emission layer, and a blue emission layer, in which the two or more layers contact each other or are separated from each other, to emit white light. In one or more embodiments, the emission layer may include two or more materials of a red light-emitting material, a green light-emitting material, and a blue light-emitting material, in which the two or more materials are mixed with each other in a single layer, to emit white light.

At least one of the emission layers may include quantum dots. For example, the green emission layer may be a quantum dot emission layer including the quantum dot, and the blue emission layer and the red emission layer may each be an organic emission layer including an organic compound.

In one or more embodiments, the emission layer may have a structure in which at least two of a red emission layer, a green emission layer, and a blue emission layer contact each other or are separated from each other. At least one emission layer of the at least two emission layers may be a quantum dot emission layer including the quantum dots, and the other emission layer may be an organic emission layer including organic compounds. Embodiments of the present disclosure are not limited thereto.

The thickness of the emission layer may be in a range of about 100 Å to about 1,000 Å, and in one or more embodiments, about 200 Å to about 600 Å. If (e.g., when) the thickness of the emission layer is within the foregoing ranges, excellent or suitable luminescence characteristics may be obtained without a substantial increase in driving voltage.

### Quantum dot

The emission layer may include a quantum dot.

The term "quantum dot" as used herein refers to a crystal of a semiconductor compound. Quantum dots may emit light of various emission wavelengths according to the size of the crystal. Quantum dots may also emit light of one or more suitable emission wavelengths by adjusting the ratio of elements constituting the quantum dots.

A diameter of the quantum dots may be, for example, in a range of about 1 nm to about 10 nm.

The quantum dot may be synthesized by a wet chemical process, a metal organic chemical vapor deposition process, a molecular beam epitaxy process, or any process similar thereto.

The wet chemical process may be a method including mixing a precursor material with an organic solvent and then growing a quantum dot particle crystal. If (e.g., when) the crystal grows, because the organic solvent naturally coordinates to the quantum dot crystal surface as a dispersing agent and controls the growth of the crystal, the growth of quantum dot particles may be controlled through an easier and lower-cost process compared to vapor deposition methods, such as metal organic chemical vapor deposition (MOCVD) and/or molecular beam epitaxy (MBE).

The quantum dot may include Group II-VI semiconductor compounds, Group III-V semiconductor compounds, Group III-VI semiconductor compounds, Group I-III-VI semiconductor compounds, Group IV-VI semiconductor compounds, a Group IV element or compound, or a combination thereof.

Examples of the Group II-VI semiconductor compounds may be binary compounds, such as CdS, CdSe, CdTe, ZnS, ZnSe, ZnTe, ZnO, HgS, HgSe, HgTe, MgSe, MgS, and/or the like; ternary compounds, such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and/or the like; it may include a quaternary compound, such as CdZnSeS, CdZnSeTe, CdZnSTe, CdHgSeS, CdHgSeTe, CdHgSTe, HgZnSeS, HgZnSeTe, HgZnSTe, and/or the like; or any combination thereof.

Examples of the Group III-V semiconductor compounds may be binary compounds, such as GaN, GaP, GaAs, GaSb, AlN, AlP, AlAs, AlSb, InN, InP, InAs, InSb, and/or the like; ternary compounds, such as GaNP, GaNAs, GaNSb, GaPAs, GaPSb, AINP, AlNAs, AlNSb, AlPAs, AlPSb, InGaP, InNP, InAlP, InNAs, InNSb, InPAs, InPSb, and/or the like; quaternary compounds, such as GaAlNP, GaAINAs, GaAlNSb, GaAlPAs, GaAlPSb, GalnNP, GalnNAs, GalnNSb, GalnPAs, GalnPSb, InAlNP, InAlNAs, InAlNSb, InAlPAs, InAlPSb, and/or the like; or any combination thereof. In one or more embodiments, the Group III-V semiconductor compound may further include a Group II element. Examples of the Group III-V semiconductor compound further including a Group II element may be InZnP, InGaZnP, InAlZnP, and/or the like.

Examples of the Group III-VI semiconductor compounds may be binary compounds, such as GaS, Ga₂S₃, GaSe, Ga₂Se₃, GaTe, InS, InSe, In₂S₃, In₂Se₃, InTe, and/or the like; ternary compounds, such as InGaS₃, InGaSe₃, and/or the like; or any combination thereof.

Examples of the Group I-III-VI semiconductor compounds may be ternary compounds, such as AgInS, AgInS₂, AgInSe₂, AgGaS, AgGaS₂, AgGaSe₂, CulnS, CuInS₂, CuInSe₂, CuGaS₂, CuGaSe₂, CuGaO₂, AgGaO₂, AgAlO₂, and/or the like; quaternary compounds, such as AgInGaS, AgInGaS₂, AgInGaSe, AgInGaSe₂, CulnGaS, CuInGaS₂ and/or the like; or any combination thereof.

Examples of the Group IV-VI semiconductor compounds may be binary compounds, such as SnS, SnSe, SnTe, PbS, PbSe, PbTe, and/or the like; ternary compounds, such as SnSeS, SnSeTe, SnSTe, PbSeS, PbSeTe, PbSTe, SnPbS, SnPbSe, SnPbTe, and/or the like; quaternary compounds, such as SnPbSSe, SnPbSeTe, SnPbSTe, and/or the like; or any combination thereof.

The Group IV element or compound may include a single element, such as Si, Ge, and/or the like; a binary compound, such as SiC, SiGe, and/or the like; or any combination thereof.

Each element included in a multicomponent compound, such as the binary compound, the ternary compound, and/or the quaternary compound, may exist in the particle at a uniform (e.g., substantially uniform) concentration or a non-uniform (e.g., substantially non-uniform) concentration. The formulae refer to the types or kinds of elements included in each compound, and the element ratios in these compounds may be different from each other. For example, AgInGaS₂ may indicate AgInₓGa₁₋ₓS₂ (where x is a real number satisfying 0<x<1).

In one or more embodiments, the quantum dot may have a single structure in which the concentration of each element in the quantum dot is uniform (e.g., substantially uniform) or a core-shell dual structure. For example, the material included in the core and the material included in the shell may be different from each other.

The shell of the quantum dot may act as a protective layer that prevents chemical degeneration of the core (or reduces a degree or occurrence of chemical degeneration of the core) to maintain semiconductor characteristics and/or as a charging layer that imparts or increases electrophoretic characteristics to the quantum dot. The shell may be a single layer or a multi-layer. The interface between the core and the shell may have a concentration gradient in which the concentration of an element that exists in the shell decreases toward the center of the core.

Examples of the shell of the quantum dot may be an oxide of a metal, metalloid, or non-metal, a semiconductor compound, and a combination thereof. Examples of the oxide of the metal, metalloid or non-metal may be binary compounds, such as SiO₂, Al₂O₃, TiO₂, ZnO, MnO, Mn₂O₃, Mn₃O₄, CuO, FeO, Fe₂O₃, Fe₃O₄, CoO, Co₃O₄, NiO, and/or the like; ternary compounds, such as MgAl₂O₄, CoFe₂O₄, NiFe₂O₄, CoMn₂O₄, and/or the like; or any combination thereof. Examples of the semiconductor compound may be: a Group III-VI semiconductor compound; a Group II-VI semiconductor compound; a Group III-V semiconductor compound; a Group III-VI semiconductor compound; a Group I-III-VI semiconductor compound; a Group IV-VI semiconductor compound; or any combination thereof, as described herein. For example, the semiconductor compound may be CdS, CdSe, CdTe, ZnS, ZnSe, ZnTe, ZnSeS, ZnTeS, GaAs, GaP, GaS, GaSe, AgGaS, AgGaS₂, GaSb, HgS, HgSe, HgTe, InAs, InP, InGaP, InSb, AlAs, AlP, AlSb, or any combination thereof.

A full width at half maximum (FWHM) of the emission wavelength spectrum of the quantum dot may be about 45 nm or less, for example, about 40 nm or less, for example, about 30 nm or less, and within the foregoing ranges, color purity or color reproducibility may be increased or enhanced. In one or more embodiments, because the light emitted through the quantum dot is emitted in all directions, the wide viewing angle may be improved or enhanced.

In one or more embodiments, a diameter of the quantum dot may be in a range of about 1 nm to about 20 nm. If (e.g., when) the average diameter of the quantum dots is within any of the foregoing ranges, specific (e.g., set or predetermined) behavior as quantum dots may be achieved, and excellent or suitable dispersability of the metal oxide composition may be obtained. In one or more embodiments, the quantum dot may be in the form of a spherical particle (e.g., a substantially spherical particle), a pyramidal particle (e.g., a substantially pyramidal particle), a multi-arm particle (e.g., a substantially multi-arm particle), a cubic nanoparticle (e.g., a substantially cubic nanoparticle), a nanotube particle (e.g., a substantially nanotube particle), a nanowire particle (e.g., a substantially nanowire particle), a nanofiber particle (e.g., a substantially nanofiber particle), or a nanoplate particle (e.g., a substantially nanoplate particle).

Because the energy band gap may be controlled by adjusting the size of the quantum dots or the elemental ratio in the quantum dot compound, light of one or more suitable wavelengths may be obtained from the quantum dot emission layer. Thus, by using quantum dots as described in one or more embodiments (by using quantum dots of different sizes or by varying the elemental ratio in a quantum dot compound), a light-emitting device that emits light of one or more suitable wavelengths may be obtained. In one or more embodiments, the size of the quantum dots or the elemental ratio in the quantum dot compound may be selected so that red light, green light, and/or blue light may be emitted. In one or more embodiments, the quantum dots may be configured or provided to emit white light by combination of light of one or more suitable colors.

The quantum dot may be synthesized by a wet chemical process, a metal organic chemical vapor deposition process, a molecular beam epitaxy process, or any process similar thereto.

The wet chemical process may be a method including mixing a precursor material with an organic solvent and then growing a quantum dot particle crystal. If (e.g., when) the crystal grows, because the organic solvent naturally coordinates to the quantum dot crystal surface as a dispersing agent and controls the growth of the crystal, the growth of quantum dot particles may be controlled through an easier and lower-cost process compared to vapor deposition methods, such as metal organic chemical vapor deposition (MOCVD) and/or molecular beam epitaxy (MBE).

In one or more embodiments, the emission layer may include a monolayer of quantum dots. In one or more embodiments, the emission layer may include a monolayer of quantum dots from (e.g., in a range of) about two layers to about 20 layers.

The thickness of the emission layer may be in a range of about 5 nm to about 200 nm, about 10 nm to about 150 nm, or for example, about 10 nm to about 100 nm.

### Electron transport region in interlayer 130

The electron transport region may have: i) a single-layered structure consisting of (e.g., including) a single layer consisting of (e.g., including) a single material, ii) a single-layered structure consisting of (e.g., including) a single layer including a plurality of different materials, or iii) a multilayer structure including a plurality of layers including a plurality of different materials.

The electron transport region may include a buffer layer, a hole-blocking layer, an electron control layer, an electron transport layer, an electron injection layer, or any combination thereof.

For example, the electron transport region may have an electron transport layer/electron injection layer structure, a hole-blocking layer/electron transport layer/electron injection layer structure, an electron control layer/electron transport layer/electron injection layer structure, or a buffer layer/electron transport layer/electron injection layer structure, wherein layers in each structure are sequentially stacked from the emission layer.

In one or more embodiments, the electron transport region may include a metal oxide layer. For example, at least one layer selected from among any combination of the buffer layer, the hole-blocking layer, the electron control layer, the electron transport layer, and the electron injection layer may be the metal oxide layer.

The metal oxide layer may include metal oxide nanoparticle and metal halides. The amount of the metal halide is in a range of greater than 0 wt% but not more than about 7.0 wt% based on the weight (e.g., based on 100 wt%) of the metal oxide nanoparticle. The amount of the metal halide may be, for example, about 0.1 wt% to about 7.0 wt%, about 1 wt% to about 7 wt% or about 2 wt% to about 5 wt%, based on the weight (e.g., based on 100 wt%) of the metal oxide nanoparticle. In one or more embodiments, the amount of the metal halide may be in a range of greater than 0 wt% to less than about 7 wt% based on the weight (e.g., based on 100 wt%) of the metal oxide nanoparticle. For example, the amount of the metal halide may be, for example, about 0.1 wt% to less than 7 wt%, or about 0.1 wt% to about 6.9 wt% based on the weight (e.g., based on 100 wt%) of the metal oxide nanoparticle.

The metal oxide nanoparticle and the metal halide may be substantially the same as described in one or more embodiments.

In one or more embodiments, the electron transport region (e.g., a buffer layer, a hole-blocking layer, an electron control layer, and/or an electron transport layer in the electron transport region) may include a metal-free compound including at least one π electron-deficient nitrogen-containing C₁-C₆₀ heterocyclic group.

In one or more embodiments, the electron transport region may include a compound represented by Formula 601.

Formula 601 [Ar₆₀₁]ₓₑ₁₁-[(L₆₀₁)ₓₑ₁-R₆₀₁]ₓₑ₂₁.

In Formula 601,
Ar₆₀₁ and L₆₀₁ may each independently be a C₃-C₆₀ carbocyclic group that is unsubstituted or substituted with at least one R₁₀ₐ or a C₁-C₆₀ heterocyclic group that is unsubstituted or substituted with at least one R₁₀ₐ,
xe11 may be 1, 2, or 3,
xe1 may be 0, 1, 2, 3, 4, or 5,
R₆₀₁ may be a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₆₀₁)(Q₆₀₂)(Q₆₀₃), -C(=O)(Q₆₀₁), -S(=O)₂(Q₆₀₁), or -P(=O)(Q₆₀₁)(Q₆₀₂),
Q₆₀₁ to Q₆₀₃ may each be the same as defined with respect to Q₁,
xe21 may be 1, 2, 3, 4, or 5, and
at least one selected from among Ar₆₀₁, L₆₀₁, and R₆₀₁ may each independently be a π electron-deficient nitrogen-containing C₁-C₆₀ heterocyclic group unsubstituted or substituted with at least one R₁₀ₐ.

In one or more embodiments, if (e.g., when) xe11 in Formula 601 is 2 or more, two or more of Ar₆₀₁ may be linked together via a single bond (e.g., a single covalent bond).

In one or more embodiments, Ar₆₀₁ in Formula 601 may be a substituted or unsubstituted anthracene group.

In one or more embodiments, the electron transport region may include a compound represented by Formula 601-1: 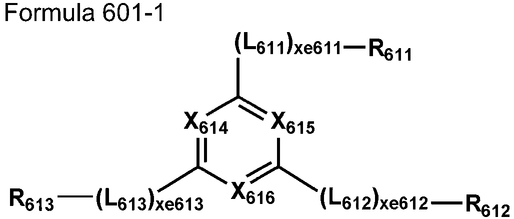 wherein, in Formula 601-1,
X₆₁₄ may be N or C(R₆₁₄), X₆₁₅ may be N or C(R₆₁₅), X₆₁₆ may be N or C(R₆₁₆), and at least one selected from among X₆₁₄ to X₆₁₆ may be N,
L₆₁₁ to L₆₁₃ may each be the same as defined with respect to L₆₀₁,
xe611 to xe613 may each be the same as defined with respect to xe1,
R₆₁₁ to R₆₁₃ may each be the same as defined with respect to R₆₀₁, and
R₆₁₄ to R₆₁₆ may each independently be hydrogen, deuterium, -F, -Cl, -Br, -I, a hydroxyl group, a cyano group, a nitro group, a C₁-C₂₀ alkyl group, a C₁-C₂₀ alkoxy group, a C₃-C₆₀ carbocyclic group that is unsubstituted or substituted with at least one R₁₀ₐ, or a C₁-C₆₀ heterocyclic group that is unsubstituted or substituted with at least one R₁₀ₐ.

In one or more embodiments, xe1 and xe611 to xe613 in Formulae 601 and 601-1 may each independently be 0, 1, or 2.

The electron transport region may include one selected from among Compounds ET1 to ET45, 2,9-dimethyl-4,7-diphenyl-1,10-phenanthroline (BCP), 4,7-diphenyl-1,10-phenanthroline (Bphen), Alq₃, BAIq, TAZ, NTAZ, or any combination thereof:

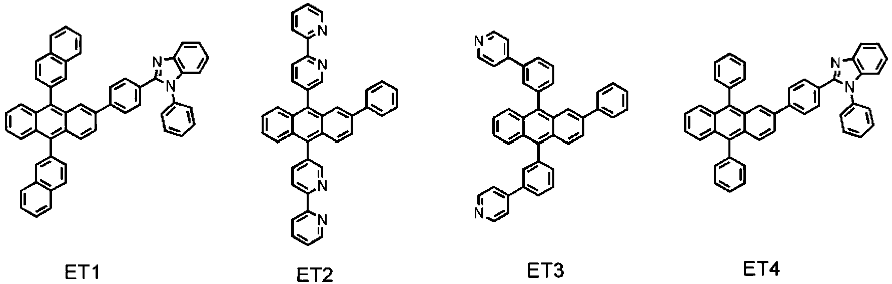

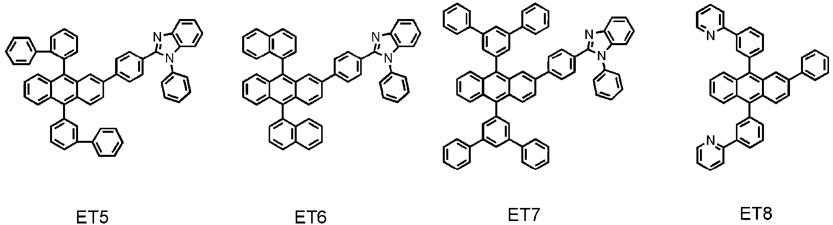

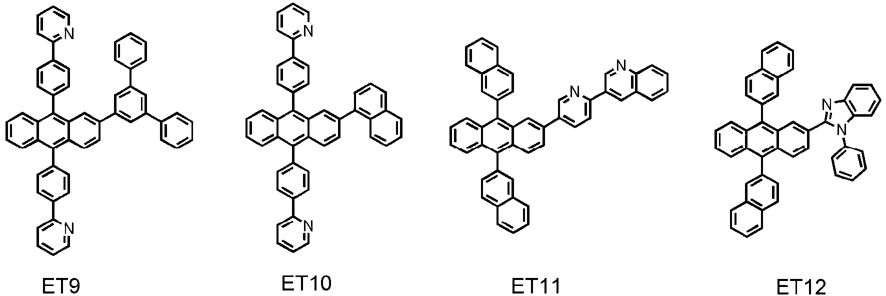

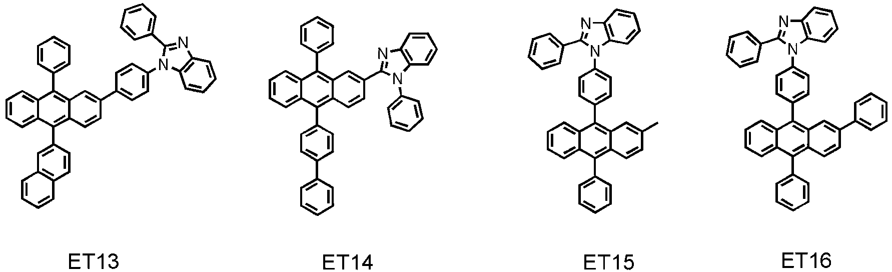

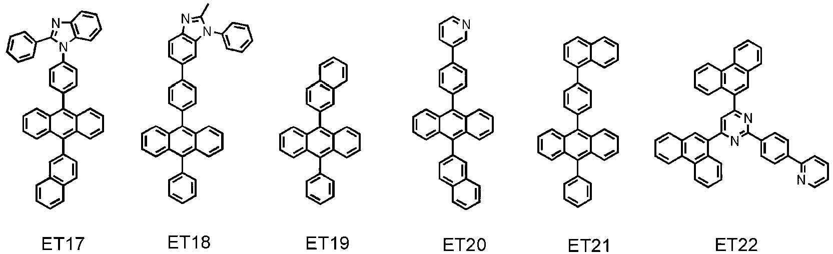

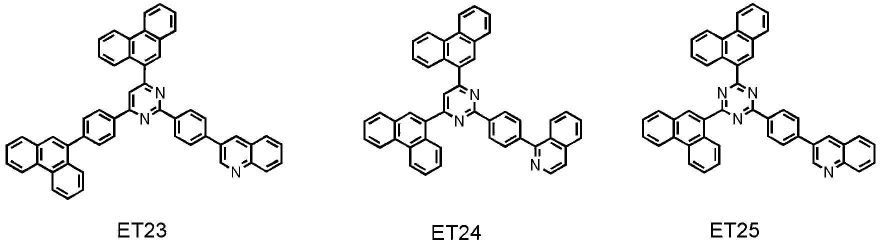

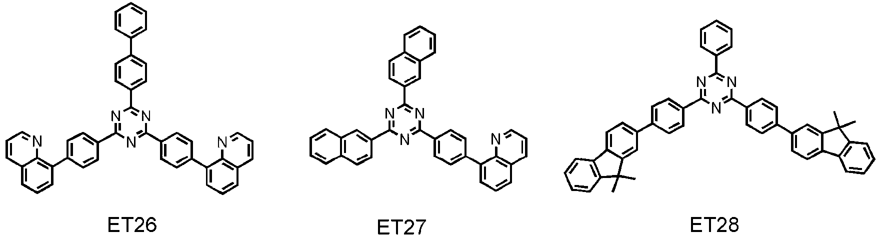

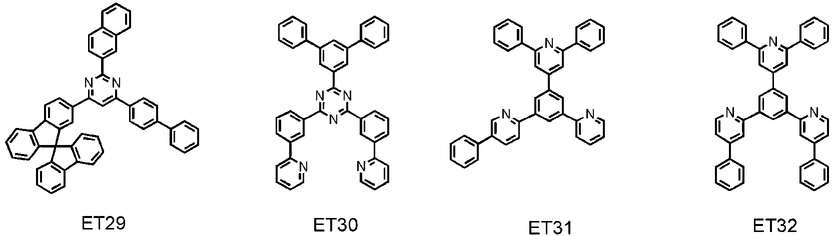

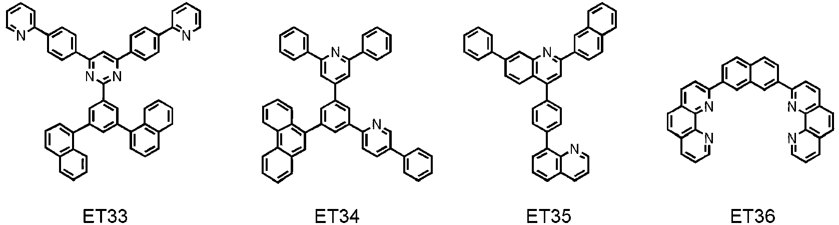

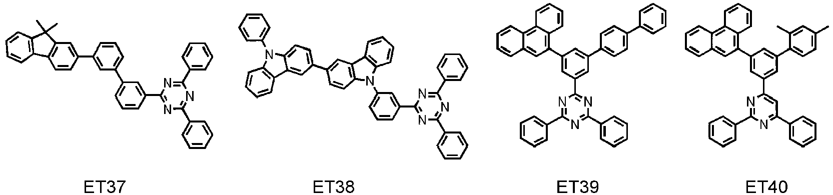

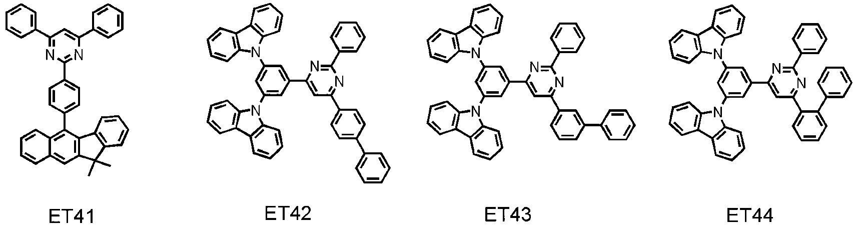

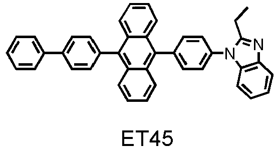

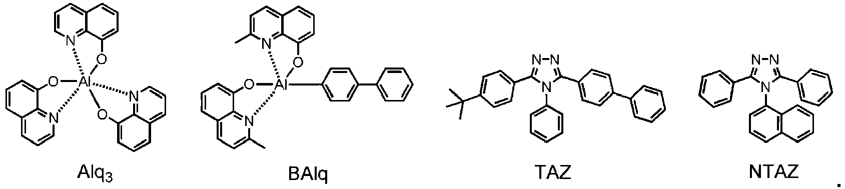

A thickness of the electron transport region may be in a range of about 100 Å to about 5,000 Å, for example, about 160 Å to about 4,000 Å. If (e.g., when) the electron transport region includes a buffer layer, a hole-blocking layer, an electron control layer, an electron transport layer, or any combination thereof, a thickness of the buffer layer, the hole-blocking layer, or the electron control layer may be in a range of about 20 Å to about 1,000 Å, for example, about 30 Å to about 300 Å, and a thickness of the electron transport layer may be in a range of about 100 Å to about 1,000 Å, for example, about 150 Å to about 500 Å. If (e.g., when) the thicknesses of the buffer layer, the hole-blocking layer, the electron control layer, the electron transport layer, and/or the electron transport region are within the foregoing ranges, the desired or satisfactory electron transporting characteristics may be obtained without a substantial increase in driving voltage.

The electron transport region (for example, the electron transport layer in the electron transport region) may further include, in addition to the materials as described in one or more embodiments, a metal-containing material.

The metal-containing material may include an alkali metal complex, an alkaline earth metal complex, or any combination thereof. A metal ion of the alkali metal complex may be a Li ion, a Na ion, a K ion, a Rb ion, or a Cs ion, and a metal ion of the alkaline earth metal complex may be a Be ion, a Mg ion, a Ca ion, a Sr ion, or a Ba ion. A ligand coordinated with the metal ion of the alkali metal complex or the alkaline earth-metal complex may include a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenylbenzimidazole, a hydroxyphenylbenzothiazole, a bipyridine, a phenanthroline, a cyclopentadiene, or any combination thereof.

In one or more embodiments, the metal-containing material may include a Li complex. The Li complex may include, for example, Compound ET-D1 (LiQ) or ET-D2:

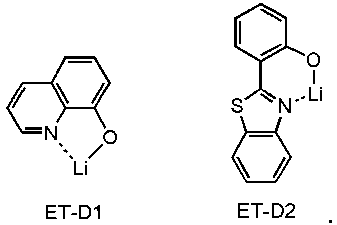

The electron transport region may include an electron injection layer that facilitates the injection of electrons from the second electrode 150. The electron injection layer may directly contact the second electrode 150.

The electron injection layer may have: i) a single-layered structure consisting of (e.g., including) a single layer consisting of (e.g., including) a single material, ii) a single-layered structure consisting of (e.g., including) a single layer including a plurality of different materials, or iii) a multilayer structure including a plurality of layers including a plurality of different materials.

The electron injection layer may include an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof.

The alkali metal may include Li, Na, K, Rb, Cs, or any combination thereof. The alkaline earth metal may include Mg, Ca, Sr, Ba, or any combination thereof. The rare earth metal may include Sc, Y, Ce, Tb, Yb, Gd, or any combination thereof.

The alkali metal-containing compound, the alkaline earth metal-containing compound, and the rare earth metal-containing compound may include oxides, halides (for example, fluorides, chlorides, bromides, iodides, and/or the like), or tellurides of the alkali metal, the alkaline earth metal, and the rare earth metal, or any combination thereof.

The alkali metal-containing compound may include: alkali metal oxides, such as Li₂O, Cs₂O, and/or K₂O; alkali metal halides, such as LiF, NaF, CsF, KF, Lil, Nal, Csl, and/or KI; or any combination thereof. The alkaline earth metal-containing compound may include an alkaline earth metal oxide, such as BaO, SrO, CaO, BaₓSr₁-ₓO (x is a real number satisfying 0<x<1), and/or BaₓCa₁₋ₓO (x is a real number satisfying 0<x<1). The rare earth metal-containing compound may include YbF₃, ScF₃, Sc₂O₃, Y₂O₃, Ce₂O₃, GdF₃, TbF₃, Ybl₃, ScI₃, TbI₃, or any combination thereof. In one or more embodiments, the rare earth metal-containing compound may include lanthanide metal telluride. Examples of the lanthanide metal telluride may be LaTe, CeTe, PrTe, NdTe, PmTe, SmTe, EuTe, GdTe, TbTe, DyTe, HoTe, ErTe, TmTe, YbTe, LuTe, La₂Te₃, Ce₂Te₃, Pr₂Te₃, Nd₂Te₃, Pm₂Te₃, Sm₂Te₃, Eu₂Te₃, Gd₂Te₃, Tb₂Te₃, Dy₂Te₃, Ho₂Te₃, Er₂Te₃, Tm₂Te₃, Yb₂Te₃, and/or Lu₂Te₃.

The alkali metal complex, the alkaline earth-metal complex, and the rare earth metal complex may be i) one of ions selected from among the alkali metal, the alkaline earth metal, and the rare earth metal and ii) a ligand bonded to the metal ion, for example, hydroxyquinoline, hydroxyisoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenyl benzimidazole, hydroxyphenylbenzothiazole, bipyridine, phenanthroline, cyclopentadiene, or any combination thereof.

The electron injection layer may consist of (e.g., include) an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof, as described in one or more embodiments. In one or more embodiments, the electron injection layer may further include an organic material (for example, a compound represented by Formula 601).

In one or more embodiments, the electron injection layer may consist of (e.g., include) i) an alkali metal-containing compound (e.g., an alkali metal halide), or ii) a) an alkali metal-containing compound (e.g., an alkali metal halide); and b) an alkali metal, an alkaline earth metal, a rare earth metal, or any combination thereof. In one or more embodiments, the electron injection layer may be a KI:Yb co-deposited layer, an Rbl:Yb co-deposited layer, a LiF:Yb co-deposited layer, and/or the like.

If (e.g., when) the electron injection layer further includes an organic material, the alkali metal, the alkaline earth metal, the rare earth metal, the alkali metal-containing compound, the alkaline earth metal-containing compound, the rare earth metal-containing compound, the alkali metal complex, the alkaline earth-metal complex, the rare earth metal complex, or any combination thereof may be uniformly (e.g., substantially uniformly) or non-uniformly (e.g., substantially non-uniformly) dispersed in a matrix including the organic material.

A thickness of the electron injection layer may be in a range of about 1 Å to about 100 Å, and, for example, about 3 Å to about 90 Å. If (e.g., when) the thickness of the electron injection layer is within the foregoing ranges, the desired or satisfactory electron injection characteristics may be obtained without a substantial increase in driving voltage.

### Second electrode 150

The second electrode 150 may be arranged or provided on the interlayer 130. The second electrode 150 may be a cathode, which is an electron injection electrode, and as a material to form or provide the second electrode 150, a metal, an alloy, an electrically conductive compound, or any combination thereof, each having a low-work function, may be used.

The second electrode 150 may include lithium (Li), silver (Ag), magnesium (Mg), aluminium (Al), aluminium-lithium (Al-Li), calcium (Ca), magnesium-indium (Mg-In), magnesium-silver (Mg-Ag), ytterbium (Yb), silver-ytterbium (Ag-Yb), ITO, IZO, or any combination thereof. The second electrode 150 may be a transmissive electrode, a transflective electrode, or a reflective electrode.

The second electrode 150 may have a single-layer structure or a multilayer structure including a plurality of layers.

### Capping layer

A first capping layer may be arranged or provided outside the first electrode 110, and/or a second capping layer may be arranged or provided outside the second electrode 150. In one or more embodiments, the light-emitting device 10 may have a structure in which the first capping layer, the first electrode 110, the interlayer 130, and the second electrode 150 are sequentially stacked in the stated order, a structure in which the first electrode 110, the interlayer 130, the second electrode 150, and the second capping layer are sequentially stacked in the stated order, or a structure in which the first capping layer, the first electrode 110, the interlayer 130, the second electrode 150, and the second capping layer are sequentially stacked in the stated order.

Light generated in the emission layer of the interlayer 130 of the light-emitting device 10 may be extracted toward the outside through the first electrode 110 which is a transflective electrode or a transmissive electrode, and the first capping layer. Light generated in the emission layer of the interlayer 130 of the light-emitting device 10 may be extracted toward the outside through the second electrode 150 which is a transflective electrode or a transmissive electrode, and the second capping layer.

The first capping layer and the second capping layer may increase or enhance external emission efficiency according to the principle of constructive interference. Accordingly, the light extraction efficiency of the light-emitting device 10 may be increased or enhanced, such that the luminescence efficiency of the light-emitting device 10 may be increased or enhanced.

Each of the first capping layer and the second capping layer may include a material having a refractive index of about 1.6 or more (at 589 nm).

The first capping layer and the second capping layer may each independently be an organic capping layer including an organic material, an inorganic capping layer including an inorganic material, or an organic-inorganic composite capping layer including an organic material and an inorganic material.

At least one selected from the first capping layer and the second capping layer may each independently include a carbocyclic compound, a heterocyclic compound, an amine group-containing compound, a porphine derivative, a phthalocyanine derivative, a naphthalocyanine derivative, an alkali metal complex, an alkaline earth metal complex, or any combination thereof. The carbocyclic compound, the heterocyclic compound, and the amine group-containing compound may optionally be substituted with a substituent including O, N, S, Se, Si, F, CI, Br, I, or any combination thereof. In one or more embodiments, at least one selected from the first capping layer and the second capping layer may each independently include an amine group-containing compound.

In one or more embodiments, at least one selected from the first capping layer and the second capping layer may each independently include a compound represented by Formula 201, a compound represented by Formula 202, or any combination thereof.

In one or more embodiments, at least one selected from the first capping layer and the second capping layer may each independently include one selected from among Compounds HT28 to HT33, one selected from among Compounds CP1 to CP6, β-NPB, or any combination thereof:

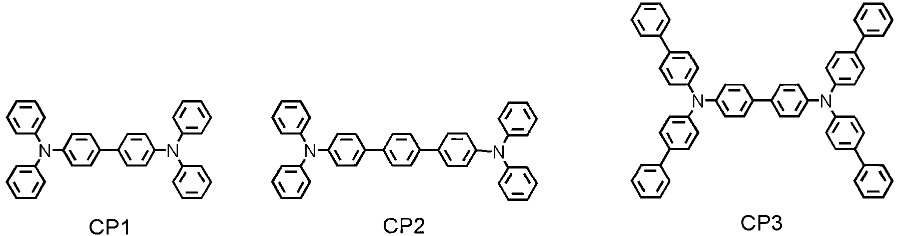

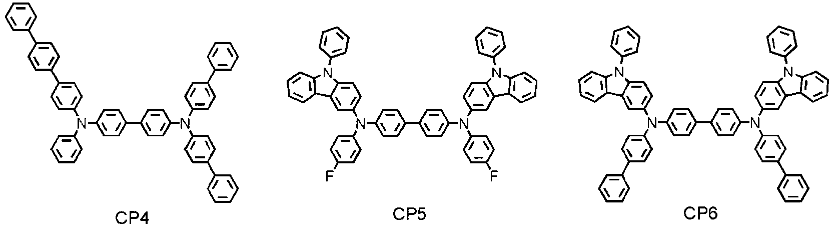

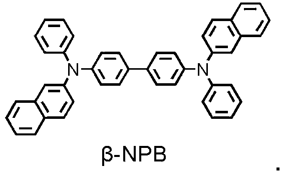

### Electronic apparatus

The light-emitting device may be included in one or more suitable electronic apparatuses. For example, an electronic apparatus including the light-emitting device may be a light-emitting apparatus, an authentication apparatus, and/or the like.

The electronic apparatus (for example, a light-emitting apparatus) may further include, in addition to the light-emitting device, i) a color filter, ii) a color conversion layer, or iii) a color filter and a color conversion layer. The color filter and/or the color conversion layer may be arranged or provided in at least one traveling direction of light emitted from the light-emitting device. For example, light emitted from the light-emitting device may be blue light, green light, or white light. A more detailed description of the light-emitting device is provided in one or more embodiments. In one or more embodiments, the color conversion layer may include quantum dots.

The electronic apparatus may include a first substrate. The first substrate may include a plurality of subpixel areas, the color filter may include a plurality of color filter areas that respectively correspond to the subpixel areas, and the color conversion layer may include a plurality of color conversion areas that respectively correspond to the subpixel areas.

A pixel-defining film may be arranged or provided among the subpixel areas to define each of the subpixel areas.

The color filter may further include a plurality of color filter areas and light-shielding patterns arranged or provided among the color filter areas, and the color conversion layer may further include a plurality of color conversion areas and light-shielding patterns arranged or provided among the color conversion areas.

The plurality of color filter areas (or the plurality of color conversion areas) may include a first area that emits first color light, a second area that emits second color light, and/or a third area that emits third color light, wherein the first color light, the second color light, and/or the third color light may have different maximum emission wavelengths. In one or more embodiments, the first color light may be red light, the second color light may be green light, and the third color light may be blue light. In one or more embodiments, the plurality of color filter areas (or the plurality of color conversion areas) may include quantum dots. For example, the first area may include red quantum dots, the second area may include green quantum dots, and the third area may not include quantum dots. A more detailed description of the quantum dots is provided herein. The first area, the second area, and/or the third area may each further include a scatterer (e.g., a light scatterer).

In one or more embodiments, the light-emitting device may emit first light, the first area may absorb the first light to emit first-first color light, the second area may absorb the first light to emit second-first color light, and the third area may absorb the first light to emit third-first color light. In one or more embodiments, the first-first color light, the second-first color light, and the third-first color light may have different maximum emission wavelengths. In one or more embodiments, the first light may be blue light, the first-first color light may be red light, the second-first color light may be green light, and the third-first color light may be blue light.

The electronic apparatus may further include a thin-film transistor, in addition to the light-emitting device as described in one or more embodiments. The thin film transistor may include a source electrode, a drain electrode, and an active layer, and one selected from the source electrode and the drain electrode may be electrically connected to one selected from the first electrode and the second electrode of the light-emitting device.

The thin-film transistor may further include a gate electrode, a gate insulating (e.g., electrically insulating) film, and/or the like.

The active layer may include crystalline silicon, amorphous (e.g., non-crystalline) silicon, an organic semiconductor, an oxide semiconductor, and/or the like.

The electronic apparatus may further include a sealing portion to seal the light-emitting device. The sealing portion may be arranged or provided between the color filter and/or the color conversion layer and the light-emitting device. The sealing portion may allow light from the light-emitting device to be extracted to the outside, and concurrently (e.g., simultaneously) prevent ambient air and/or moisture from penetrating into the light-emitting device (or reduce a degree to or occurrence of which ambient air and/or moisture penetrate into the light-emitting device). The sealing portion may be a sealing substrate including a transparent (e.g., substantially transparent) glass substrate and/or a plastic substrate. The sealing portion may be a thin-film encapsulation layer including at least one layer selected from an organic layer and an inorganic layer. If (e.g., when) the sealing portion is a thin film encapsulation layer, the electronic apparatus may be flexible.

One or more suitable functional layers may be additionally arranged or provided on the sealing portion, in addition to the color filter and/or the color conversion layer, according to the use of the electronic apparatus. Examples of the functional layers may be a touch screen layer and/or a polarizing layer. The touch screen layer may be a pressure-sensitive touch screen layer, a capacitive touch screen layer, and/or an infrared touch screen layer. The authentication apparatus may be, for example, a biometric authentication apparatus that authenticates an individual by using biometric information of a living body (for example, fingertips, pupils, and/or the like).

The authentication apparatus may further include, in addition to the light-emitting device as described in one or more embodiments, a biometric information collector.

The electronic apparatus may be applied to one or more suitable displays, light sources, lighting, personal computers (for example, a mobile personal computer), mobile phones, digital cameras, electronic organizers, electronic dictionaries, electronic game machines, medical instruments (for example, electronic thermometers, sphygmomanometers, blood glucose meters, pulse measurement devices, pulse wave measurement devices, electrocardiogram displays, ultrasonic diagnostic devices, and/or endoscope displays), fish finders, one or more suitable measuring instruments, meters (for example, meters for a vehicle, an aircraft, and/or a vessel), projectors, and/or the like.

### Electronic device

The light-emitting device may be included in one or more suitable electronic devices.

In one or more embodiments, the electronic device including the light-emitting device may be one selected from among a flat panel display, a curved display, a computer monitor, a medical monitor, a television, a billboard, an indoor light, an outdoor light, a signal light, a head-up display, a fully transparent display, a partially transparent display, a flexible display, a rollable display, a foldable display, a stretchable display, a laser printer, a telephone, a mobile phone, a tablet, a phablet, a personal digital assistant (PDA), a wearable device, a laptop computer, a digital camera, a camcorder, a viewfinder, a micro display, a 3D display, a virtual display, an augmented-reality display, a vehicle, a video wall including a plurality of displays tiled together, a theater screen, a stadium screen, a phototherapy device, and a signboard.

Because the light-emitting device has excellent or suitable effects in terms of luminescence efficiency long lifespan, the electronic device including the light-emitting device may have characteristics having high luminance, high resolution, and low power consumption.

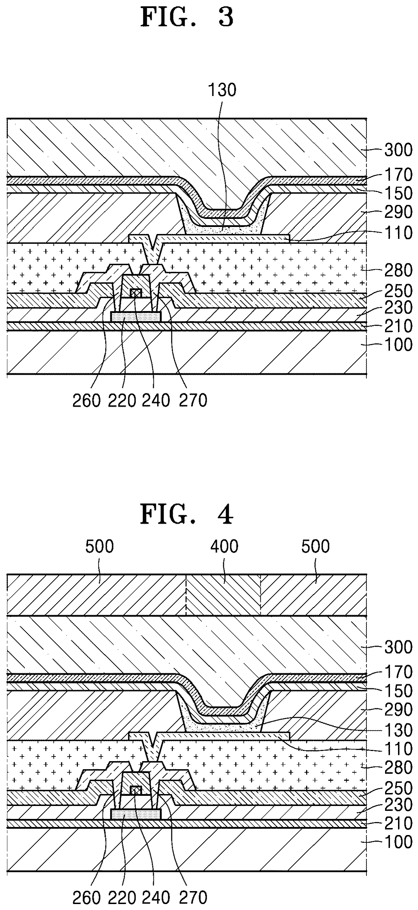

FIG. 3 is a drawing schematically illustrating the structure of a light-emitting device, which is one of electronic apparatuses according to one or more embodiments.

The light-emitting apparatus of FIG. 3 includes a substrate 100, a thin-film transistor (TFT), a light-emitting device, and an encapsulation portion 300 that seals the light-emitting device.

The substrate 100 may be a flexible substrate, a glass substrate, or a metal substrate. A buffer layer 210 may be arranged or provided on the substrate 100. The buffer layer 210 may prevent penetration of impurities through the substrate 100 (or reduce a degree to or occurrence of which impurities penetrate through the substrate 100) and may provide a flat surface (e.g., a substantially flat surface) on the substrate 100.

A TFT may be arranged or provided on the buffer layer 210. The TFT may include an active layer 220, a gate electrode 240, a source electrode 260, and a drain electrode 270.

The active layer 220 may include an inorganic semiconductor, such as silicon and/or polysilicon, an organic semiconductor, and/or an oxide semiconductor, and may include a source region, a drain region, and a channel region.

A gate insulating film 230 to insulate the active layer 220 from the gate electrode 240 may be arranged or provided on the active layer 220, and the gate electrode 240 may be arranged or provided on the gate insulating film 230.

An interlayer insulating film 250 may be arranged or provided on the gate electrode 240. The interlayer insulating film 250 may be arranged or provided between the gate electrode 240 and the source electrode 260 and between the gate electrode 240 and the drain electrode 270, to insulate these electrodes from one another.

The source electrode 260 and the drain electrode 270 may be arranged or provided on the interlayer insulating film 250. The interlayer insulating film 250 and the gate insulating film 230 may be formed or provided to expose the source region and the drain region of the active layer 220, and the source electrode 260 and the drain electrode 270 may be arranged or provided in contact with the exposed portions of the source region and the drain region of the active layer 220.

The TFT may be electrically connected to a light-emitting device to drive the light-emitting device, and may be covered and protected by a passivation layer 280. The passivation layer 280 may include an inorganic insulating (e.g., electrically insulating) film, an organic insulating (e.g., electrically insulating) film, or any combination thereof. A light-emitting device may be provided on the passivation layer 280. The light-emitting device may include the first electrode 110, the interlayer 130, and the second electrode 150.

The first electrode 110 may be arranged or provided on the passivation layer 280. The passivation layer 280 may be arranged or provided to expose a portion of the drain electrode 270, not fully covering the drain electrode 270, and the first electrode 110 may be arranged or provided to be connected to the exposed portion of the drain electrode 270.

A pixel-defining film 290 including an insulating (e.g., electrically insulating) material may be arranged or provided on the first electrode 110. The pixel-defining film 290 may expose a certain (e.g., set or predetermined) region of the first electrode 110, and the interlayer 130 may be formed or provided in the exposed region of the first electrode 110. The pixel-defining film 290 may be a polyimide-based organic film and/or a polyacrylic organic film. In one or more embodiments, at least one or more layers of the interlayer 130 may extend beyond the upper portion of the pixel-defining layer 290 and may thus be arranged or provided in the form of a common layer.

The second electrode 150 may be arranged or provided on the interlayer 130, and a second capping layer 170 may be additionally formed or provided on the second electrode 150. The second capping layer 170 may be formed or provided to cover the second electrode 150.

The encapsulation portion 300 may be arranged or provided on the second capping layer 170. The encapsulation portion 300 may be disposed or provided on a light-emitting device to protect the light-emitting device from moisture and/or oxygen. The encapsulation portion 300 may include: an inorganic film including silicon nitride (e.g., Si₃N₄ or SiNₓ, wherein 0 < x ≤ 2), silicon oxide (e.g., SiOₓ, wherein 0 < x ≤ 2; e.g., SiO₂), indium tin oxide, indium zinc oxide, or any combination thereof; an organic film including polyethylene terephthalate, polyethylene naphthalate, polycarbonate, polyimide, polyethylene sulfonate, polyoxymethylene, polyarylate, hexamethyldisiloxane, an acrylic-based resin (for example, polymethyl methacrylate, polyacrylic acid, and/or the like), an epoxy-based resin (for example, aliphatic glycidyl ether (AGE) and/or the like), or any combination thereof; or a combination of the inorganic film and the organic film.

FIG. 4 is a drawing schematically illustrating the structure of a light-emitting apparatus, which is one of electronic apparatuses according to one or more embodiments.

The light-emitting apparatus of FIG. 4 is substantially the same as the light-emitting apparatus of FIG. 3, except that a light-shielding pattern 500 and a functional region 400 are additionally located or provided on the encapsulation portion 300. The functional region 400 may be i) a color filter area, ii) a color conversion area, or iii) a combination of the color filter area and the color conversion area. In one or more embodiments, the light-emitting device included in the light-emitting device of FIG. 4 may be a tandem light-emitting device.

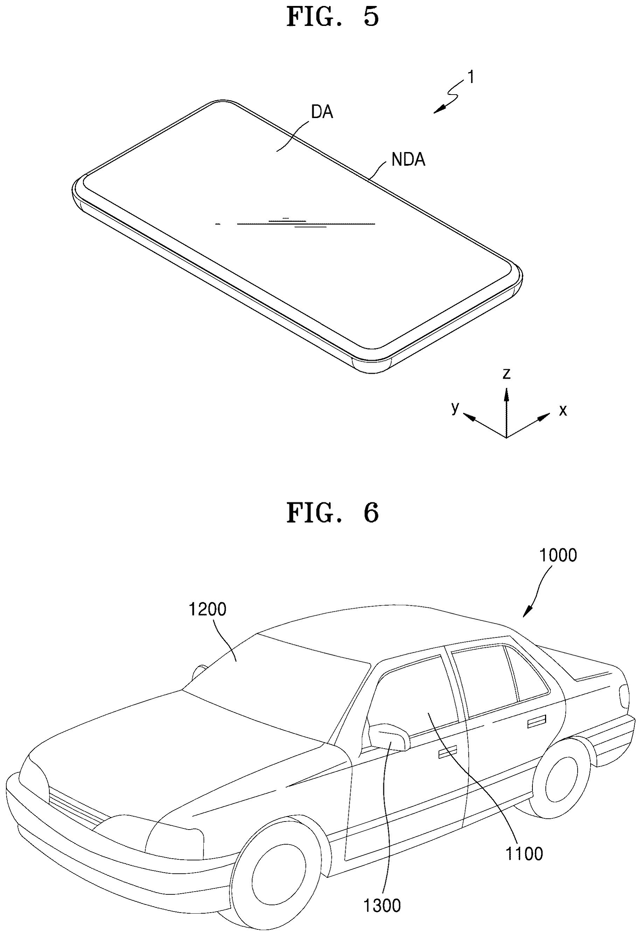

FIG. 5 is a schematic drawing of an electronic device 1 including a light-emitting device according to one or more embodiments. The electronic device 1 may be, as an apparatus that displays a moving image and/or a still image, portable electronic device, such as a mobile phone, a smartphone, a tablet personal computer (PC), a mobile communication terminal, an electronic notebook, an electronic book, a portable multimedia player (PMP), a navigation, and/or an ultra-mobile PC (UMPC), as well as one or more suitable products, such as a television, a laptop, a monitor, a billboard, and/or an Internet of things (IoT) device. The electronic device 1 may be such a product as described in one or more embodiments or a part thereof. In one or more embodiments, the electronic device 1 may be a wearable device, such as a smart watch, a watch phone, a glasses-type or kind display, and/or a head mounted display (HMD), or a part of the wearable device. However, embodiments of the present disclosure are not limited thereto. In one or more embodiments, the electronic device 1 may be a dashboard of a vehicle, a center information display (CID) arranged or provided on a center fascia or dashboard of a vehicle, a room mirror display instead of a side-view mirror of a vehicle, an entertainment for the back seat of a vehicle, or a display arranged or provided on the back of the front seat of a vehicle, a head up display (HUD) installed on the front of a vehicle or projected on a front window glass, and/or a computer generated hologram augmented reality head up display (CGH AR HUD). FIG. 5 illustrates one or more embodiments in which the electronic device 1 is a smartphone for convenience of explanation.

The electronic device 1 may include a display area DA and a non-display area NDA outside the display area DA. A display apparatus may implement or display an image through an array of a plurality of pixels that are two-dimensionally arranged or provided in the display area DA.

The non-display area NDA may be an area that does not display an image, and may entirely be around (e.g., surround) the display area DA. On the non-display area NDA, a driver to provide electrical signals or power to display devices arranged or provided on the display area DA may be arranged or provided. On the non-display area NDA, a pad, which is an area to which an electronic element or a printed circuit board, may be electrically connected may be arranged or provided.

In the electronic device 1, the length in an x-axis direction and the length in a y-axis direction may be different from each other. In one or more embodiments, as shown in FIG. 5, the length in the x-axis direction may be less than the length in the y-axis direction. In one or more embodiments, the length in the x-axis direction may be substantially the same as the length in the y-axis direction. In one or more embodiments, the length in the x-axis direction may be greater than the length in the y-axis direction.

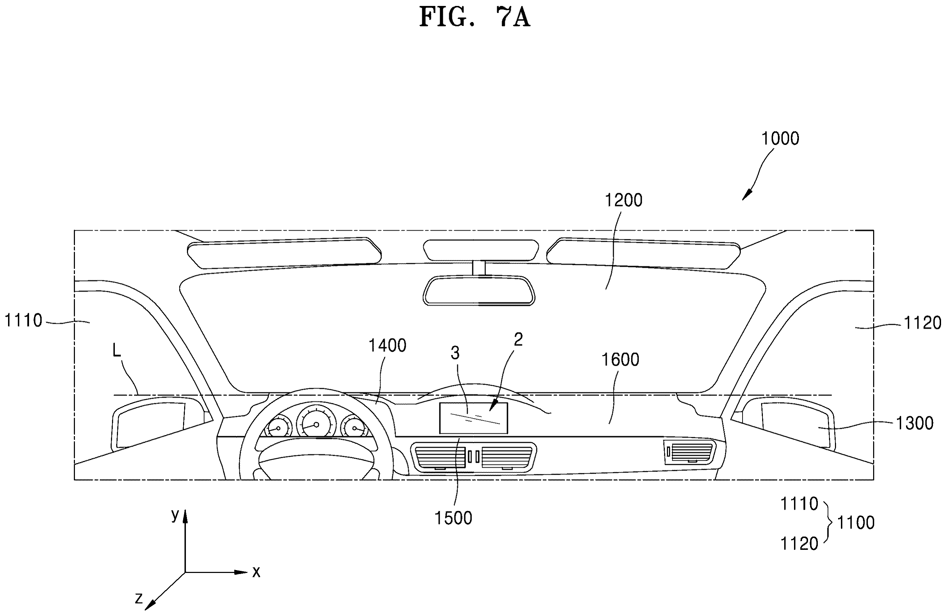

FIG. 6 is a diagram illustrating the exterior of a vehicle 1000 as an electronic device including a light-emitting device according to one or more embodiments. FIGS. 7A to 7C are each a diagram schematically illustrating the interior of a vehicle 1000 according to one or more embodiments.

Referring to FIGS. 6 and 7A to 7C, the vehicle 1000 may refer to one or more suitable apparatuses to move a subject to be transported, such as a human, an object, and/or an animal, from a departure point to a destination point. The vehicle 1000 may include a vehicle that travels on a road or track, a vessel that moves over the sea or river, an airplane that flies in the sky using the action of air, and/or the like.

The vehicle 1000 may travel on a road or a track. The vehicle 1000 may move in a certain (e.g., set or predetermined) direction according to rotation of at least one wheel. In one or more embodiments, the vehicle 1000 may include a three-wheeled or four-wheeled vehicle, a construction machine, a two-wheeled vehicle, a prime mover device, a bicycle, and a train running on a track.

The vehicle 1000 may include a body having an interior and an exterior, and a chassis in which mechanical apparatuses to drive are installed as other parts except for the body of the vehicle 1000. The exterior of the body of the vehicle may include a front panel, a bonnet, a roof panel, a rear panel, a trunk, a pillar provided at a boundary between doors, and/or the like. The chassis of the vehicle 1000 may include a power generating device, a power transmitting device, a driving device, a steering device, a braking device, a suspension device, a transmission device, a fuel device, front and rear wheels, left and right wheels, and/or the like.

The vehicle 1000 may include a side window glass 1100, a front window glass 1200, a side-view mirror 1300, a cluster 1400, a center fascia 1500, a passenger seat dashboard 1600, and a display apparatus 2.

The side window glass 1100 and the front window glass 1200 may be partitioned by a pillar arranged or provided between the side window glass 1100 and the front window glass 1200.

The side window glass 1100 may be installed on the side of the vehicle 1000. In one or more embodiments, the side window glass 1100 may be installed on a door of the vehicle 1000. A plurality of side window glasses 1100 may be provided and may be opposite to (e.g., face) each other. In one or more embodiments, the side window glass 1100 may include a first side window glass 1110 and a second side window glass 1120. In one or more embodiments, the first side window glass 1110 may be arranged or provided adjacent to the cluster 1400. The second side window glass 1120 may be arranged or provided adjacent to the passenger seat dashboard 1600.

In one or more embodiments, the side window glasses 1100 may be spaced and/or apart (e.g., spaced apart or separated) from each other in an x direction or a -x direction. In one or more embodiments, the first side window glass 1110 and the second side window glass 1120 may be spaced and/or apart (e.g., spaced apart or separated) from each other in the x direction or the -x direction. For example, an imaginary straight line L that connects the side window glasses 1100 may extend in the x direction or the -x direction. In one or more embodiments, an imaginary straight line L that connects the first side window glass 1110 and the second side window glass 1120 to each other may extend in the x direction or the -x direction.

The front window glass 1200 may be installed in front of the vehicle 1000. The front window glass 1200 may be arranged or provided between the side window glasses 1100 opposite to (e.g., facing) each other.

The side-view mirror 1300 may provide a rear view of the vehicle 1000. The side-view mirror 1300 may be installed on the exterior of the body of the vehicle. In one or more embodiments, a plurality of side-view mirrors 1300 may be provided. Any one of the plurality of side-view mirrors 1300 may be arranged or provided outside the first side window glass 1110. Another of the plurality of side-view mirrors 1300 may be arranged or provided outside the second side window glass 1120.

The cluster 1400 may be arranged or provided in front of a steering wheel. The cluster 1400 may include a tachometer, a speedometer, a coolant thermometer, a fuel gauge, a turn signal indicator, a high beam indicator, a warning light, a seat belt warning light, an odometer, a tachograph, an automatic shift selector indicator, a door open warning light, an engine oil warning light, and/or a low fuel warning light.

The center fascia 1500 may include a control panel on which a plurality of buttons to adjust an audio device, an air conditioning device, and a seat heater are disposed. The center fascia 1500 may be arranged or provided on one side of the cluster 1400.

The passenger seat dashboard 1600 may be spaced and/or apart (e.g., spaced apart or separated) from the cluster 1400, and the center fascia 1500 may be arranged or provided between the cluster 1400 and the passenger seat dashboard 1600. In one or more embodiments, the cluster 1400 may be arranged or provided to correspond to a driver seat, and the passenger seat dashboard 1600 may be arranged or provided to correspond to a passenger seat. In one or more embodiments, the cluster 1400 may be adjacent to the first side window glass 1110, and the passenger seat dashboard 1600 may be adjacent to the second side window glass 1120.

In one or more embodiments, the display apparatus 2 may include a display panel 3, and the display panel 3 may display an image. The display apparatus 2 may be arranged or provided inside the vehicle 1000. In one or more embodiments, the display apparatus 2 may be arranged or provided between the side window glasses 1100 opposite to (e.g., facing) each other. The display apparatus 2 may be arranged or provided on at least one selected from among the cluster 1400, the center fascia 1500, and the passenger seat dashboard 1600.

The display apparatus 2 may include an organic light-emitting display, an inorganic electroluminescent display, a quantum dot display, and/or the like. Hereinafter, as the display apparatus 2 according to one or more embodiments, an organic light-emitting display apparatus including the light-emitting device will be described in more detail as an example, but one or more suitable types or kinds of display apparatuses as described in one or more embodiments may be used herein.

Referring to FIG. 7A, the display apparatus 2 may be arranged or provided on the center fascia 1500. In one or more embodiments, the display apparatus 2 may display navigation information. In one or more embodiments, the display apparatus 2 may display information regarding audio settings, video setting, and/or vehicle settings.

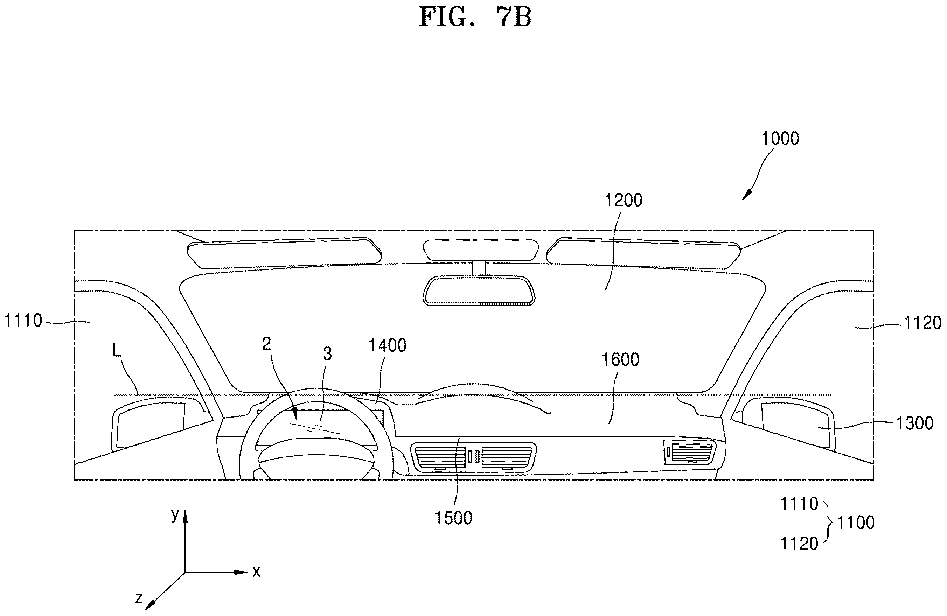

Referring to FIG. 7B, the display apparatus 2 may be arranged or provided on the cluster 1400. In one or more embodiments, the cluster 1400 may display driving information and/or the like through the display apparatus 2. For example, the driving information may be implemented on the cluster 1400 in a digital manner. The cluster 1400 that operates in a digital manner may display vehicle information and driving information in the form of images. In one or more embodiments, a needle and a gauge of a tachometer and one or more suitable warning light icons may be displayed by a digital signal.

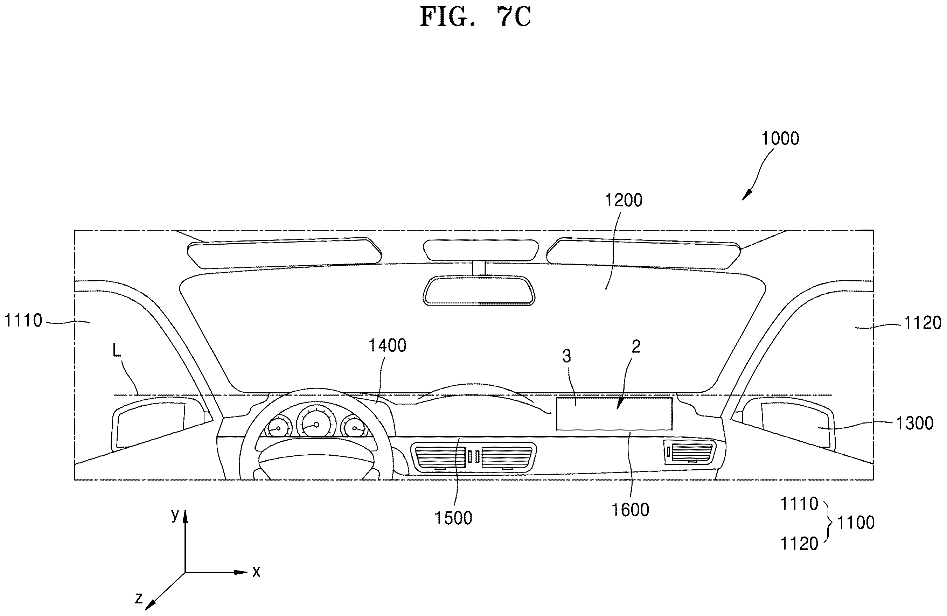

Referring to FIG. 7C, the display apparatus 2 may be arranged or provided on the passenger seat dashboard 1600. The display apparatus 2 may be embedded in the passenger seat dashboard 1600 or arranged or provided on the passenger seat dashboard 1600. In one or more embodiments, the display apparatus 2 arranged or provided on the passenger seat dashboard 1600 may display an image related to information displayed on the cluster 1400 and/or information displayed on the center fascia 1500. In one or more embodiments, the display apparatus 2 arranged or provided on the passenger seat dashboard 1600 may display information different from information displayed on the cluster 1400 and/or information displayed on the center fascia 1500.

### Manufacturing method

The layers that constitute the hole transport region, the emission layer, and the layers that constitute the electron transport region may be formed or provided in a certain (e.g., set or predetermined) region by using one or more suitable methods, such as vacuum deposition, spin coating, casting, Langmuir-Blodgett (LB) deposition, ink-jet printing, laser-printing, laser-induced thermal imaging, and/or the like.

If (e.g., when) the layers that constitute the hole transport region, the emission layer, and the layers that constitute the electron transport region are formed or provided by vacuum deposition, the deposition may be performed at a deposition temperature in a range of about 100 °C to about 500 °C, at a vacuum degree in a range of about 10⁻⁸ torr to about 10⁻³ torr, and at a deposition speed in a range of about 0.01 Å/sec to about 100 Å/sec, depending on a material to be included in a layer to be formed or provided and the structure of a layer to be formed or provided.

### Definition of terms

The term "C₃-C₆₀ carbocyclic group" as used herein refers to a cyclic group consisting of (e.g., including) carbon atoms as the only ring-forming atoms and having three to sixty carbon atoms, and the term "C₁-C₆₀ heterocyclic group" as used herein refers to a cyclic group that has one to sixty carbon atoms and further includes, in addition to a carbon atom, a heteroatom as a ring-forming atom. The C₃-C₆₀ carbocyclic group and the C₁-C₆₀ heterocyclic group may each be a monocyclic group consisting of (e.g., including) one ring or a polycyclic group in which two or more rings are condensed with each other. In one or more embodiments, the number of ring-forming atoms of the C₁-C₆₀ heterocyclic group may be 3 to 61.

The "cyclic group" as used herein may include both (e.g., simultaneously) the C₃-C₆₀ carbocyclic group and the C₁-C₆₀ heterocyclic group.

In one or more embodiments, the term "electron-rich C₃-C₆₀ cyclic group" refers to a cyclic group having 3 to 60 carbon atoms that does not include *-N=*' as a ring-forming moiety, and the term "electron-deficient nitrogen-containing C₁-C₆₀ heterocyclic group" refers to a heterocyclic group having 1 to ₆₀ carbon atoms that includes *-N=*' as a ring-forming moiety.

In one or more embodiments,
the C₃-C₆₀ carbocyclic group may be i) Group T1 or ii) a condensed cyclic group in which two or more of Group T1 are condensed with each other (for example, a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),
the C₁-C₆₀ heterocyclic group may be i) Group T2, ii) a condensed cyclic group in which two or more of Group T2 are condensed with each other, or iii) a condensed cyclic group in which at least one Group T2 and at least one Group T1 are condensed with each other (e.g., a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, and/or the like),
the π electron-rich C₃-C₆₀ cyclic group may be i) Group T1, ii) a condensed cyclic group in which two or more Groups T1 are condensed with each other, iii) Group T3, iv) a condensed cyclic group in which two or more Groups T3 are condensed with each other, or v) a condensed cyclic group in which at least one Group T3 and at least one Group T1 are condensed with each other (for example, the C₃-C₆₀ carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, and/or the like),
the π electron-deficient nitrogen-containing C₁-C₆₀ heterocyclic group is i) a group T4, ii) a condensed ring group in which two or more groups T4 are condensed with each other, iii) a condensed ring group in which one or more groups T4 and one or more groups T1 are condensed with each other, iv) a condensed ring group in which one or more groups T4 and one or more groups T3 are condensed with each other, or v) a condensed ring group in which one or more groups T4, one or more groups T1 and one or more groups T3 are condensed with each other (for example, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, (pyrazine group, pyridazine group, triazine group, quinoline group, isoquinoline group, benzoquinoline group, benzoisoquinoline group, quinoxaline group, benzoquinoxaline group, quinazoline group, benzoquinazoline group, phenanthroline group, cinnoline group, phthalazine group, naphthyridine group, imidazopyridine group, imidazopyrimidine group, imidazotriazine group, imidazopyrazine group, imidazopyridazine group, azacarbazole group, azafluorene group, azadibenzosilole group, azadibenzothiophene group, azadibenzofuran group, and/or the like),
Group T1 may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or bicyclo[2.2.1]heptane) group, a norbornene group, a bicyclo[1.1.1]pentane group, a bicyclo[2.1.1]hexane group, a bicyclo[2.2.2]octane group, or a benzene group,
Group T2 may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a tetrahydropyrazine group, a dihydropyrazine group, a tetrahydropyridazine group, or a dihydropyridazine group,
Group T3 may be a furan group, a thiophene group, a 1H-pyrrole group, a silole group, or a borole group, and
Group T4 may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The terms a cyclic group, a C₃-C₆₀ carbocyclic group, a C₁-C₆₀ heterocyclic group, a π electron-rich C₃-C₆₀ cyclic group, or a π electron-deficient nitrogen-containing C₁-C₆₀ heterocyclic group as used herein may be a group fused to any cyclic group, a monovalent group, or a polyvalent group (e.g., a divalent group, a trivalent group, a tetravalent group, and/or the like), depending on the structure of the chemical formula in which the term is used. In one or more embodiments, "a benzene group" may be a benzo group, a phenyl group, a phenylene group, and/or the like, which may be easily understand by one of ordinary skill in the art according to the structure of a formula including the "benzene group."

Examples of the monovalent C₃-C₆₀ carbocyclic group and the monovalent C₁-C₆₀ heterocyclic group may be a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, and a monovalent non-aromatic condensed heteropolycyclic group. Examples of the divalent C₃-C₆₀ carbocyclic group and the divalent C₁-C₆₀ heterocyclic group may be a C₃-C₁₀ cycloalkylene group, a C₁-C₁₀ heterocycloalkylene group, a C₃-C₁₀ cycloalkenylene group, a C₁-C₁₀ heterocycloalkenylene group, a C₆-C₆₀ arylene group, a C₁-C₆₀ heteroarylene group, a divalent non-aromatic condensed polycyclic group, and a divalent non-aromatic condensed heteropolycyclic group.

The term "C₁-C₆₀ alkyl group" as used herein refers to a linear or branched aliphatic hydrocarbon monovalent group that has one to sixty carbon atoms, and examples thereof may be a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, and a tert-decyl group. The term "C₁-C₆₀ alkylene group" as used herein refers to a divalent group having the same structure as the C₁-C₆₀ alkyl group.

The term "C₂-C₆₀ alkenyl group" as used herein refers to a monovalent hydrocarbon group having at least one carbon-carbon double bond in the middle or at the terminus of the C₂-C₆₀ alkyl group, and examples thereof may include an ethenyl group, a propenyl group, and a butenyl group. The term "C₂-C₆₀ alkenylene group" as used herein refers to a divalent group having the same structure as the C₂-C₆₀ alkenyl group.

The term "C₂-C₆₀ alkynyl group" as used herein refers to a monovalent hydrocarbon group having at least one carbon-carbon triple bond in the middle or at the terminus of the C₂-C₆₀ alkyl group, and examples thereof may include an ethynyl group and a propynyl group. The term "C₂-C₆₀ alkynylene group" as used herein refers to a divalent group having the same structure as the C₂-C₆₀ alkynyl group.

The term "C₁-C₆₀ alkoxy group" as used herein refers to a monovalent group represented by -OA₁₀₁ (wherein A₁₀₁ is the C₁-C₆₀ alkyl group), and examples thereof may include a methoxy group, an ethoxy group, and an isopropyloxy group.

The term "C₃-C₁₀ cycloalkyl group" as used herein refers to a monovalent saturated hydrocarbon cyclic group having 3 to 10 carbon atoms, and examples thereof may include a cyclopropyl group, a cyclobutyl group, a cyclopentyl group, a cyclohexyl group, a cycloheptyl group, a cyclooctyl group, an adamantanyl group, a norbornanyl group (or bicyclo[2.2.1]heptyl group), a bicyclo[1.1.1]pentyl group, a bicyclo[2.1.1]hexyl group, a bicyclo[2.2.2]octyl group, and/or the like. The term "C₃-C₁₀ cycloalkylene group" as used herein refers to a divalent group having the same structure as the C₃-C₁₀ cycloalkyl group.

The term "C₁-C₁₀ heterocycloalkyl group" as used herein refers to a monovalent cyclic group that has one to ten carbon atoms and further includes, in addition to the carbon atoms, at least one heteroatom as a ring-forming atom, and examples thereof may include a 1,2,3,4-oxatriazolidinyl group, a tetrahydrofuranyl group, and a tetrahydrothiophenyl group. The term "C₁-C₁₀ heterocycloalkylene group" as used herein refers to a divalent group having the same structure as the C₁-C₁₀ heterocycloalkyl group.

The term "C₃-C₁₀ cycloalkenyl group" as used herein refers to a monovalent cyclic group that has three to ten carbon atoms and at least one carbon-carbon double bond in the ring thereof and no aromaticity, and examples thereof may be a cyclopentenyl group, a cyclohexenyl group, and a cycloheptenyl group. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent cyclic group that has one to ten carbon atoms, further includes, in addition to the carbon atoms, at least one heteroatom as a ring-forming atom, and has at least one double bond in the ring thereof. Examples of the C₁-C₁₀ heterocycloalkenyl group may be a 4,5-dihydro-1,2,3,4-oxatriazolyl group, a 2,3-dihydrofuranyl group, and a 2,3-dihydrothiophenyl group. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic system of six to sixty carbon atoms, and the term "C₆-C₆₀ arylene group" as used herein refers to a divalent group having a carbocyclic aromatic system of six to sixty carbon atoms. Examples of the C₆-C₆₀ aryl group may be a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, and an ovalenyl group. If (e.g., when) the C₆-C₆₀ aryl group and the C₆-C₆₀ arylene group each include two or more rings, the two or more rings may be condensed with each other.

The term "C₁-C₆₀ heteroaryl group" as used herein refers to a monovalent group having a heterocyclic aromatic system that has one to sixty carbon atoms and further includes, in addition to the carbon atoms, at least one heteroatom as a ring-forming atom. The term "C₁-C₆₀ heteroarylene group" as used herein refers to a divalent group having a heterocyclic aromatic system that has one to sixty carbon atoms and further includes, in addition to the carbon atoms, at least one heteroatom as a ring-forming atom. Examples of the C₁-C₆₀ heteroaryl group may include a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, and a naphthyridinyl group. If (e.g., when) the C₁-C₆₀ heteroaryl group and the C₁-C₆₀ heteroarylene group each include two or more rings, the two or more rings may be condensed with each other.

The term "monovalent non-aromatic condensed polycyclic group" as used herein refers to a monovalent group having two or more rings condensed with each other, only carbon atoms (for example, eight to sixty carbon atoms) as ring-forming atoms, and no aromaticity in its molecular structure if (e.g., when) considered as a whole. Examples of the monovalent non-aromatic condensed polycyclic group may be an indenyl group, a fluorenyl group, a spiro-bifluorenyl group, a benzofluorenyl group, an indenophenanthrenyl group, and an indeno anthracenyl group. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent group that has two or more rings condensed with each other, further includes, in addition to carbon atoms (for example, one to sixty carbon atoms), at least one heteroatom as a ring-forming atom, and has no aromaticity in its molecular structure if (e.g., when) considered as a whole. Examples of the monovalent non-aromatic condensed heteropolycyclic group may be a pyrrolyl group, a thiophenyl group, a furanyl group, an indolyl group, a benzoindolyl group, a naphtho indolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indenocarbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphthosilolyl group, a benzofurodibenzofuranyl group, a benzofurodibenzothiophenyl group, a benzothienodibenzothiophenyl group, and/or the like. The term "divalent non-aromatic condensed heteropolycyclic group" as used herein refers to a divalent group having the same structure as the monovalent non-aromatic condensed heteropolycyclic group.

The term "C₆-C₆₀ aryloxy group" as used herein indicates -OA₁₀₂ (wherein A₁₀₂ is the C₆-C₆₀ aryl group), and the term "C₆-C₆₀ arylthio group" as used herein indicates -SA₁₀₃ (wherein A₁₀₃ is the C₆-C₆₀ aryl group).

The term "C₇-C₆₀ arylalkyl group" as used herein refers to -A₁₀₄A₁₀₅ (wherein A₁₀₄ is a C₁-C₅₄ alkylene group, and A₁₀₅ is a C₆-C₅₉ aryl group), and the term "C₂-C₆₀ heteroarylalkyl group" as used herein refers to -A₁₀₆A₁₀₇ (wherein A₁₀₆ is a C₁-C₅₉ alkylene group, and A₁₀₇ is a C₁-C₅₉ heteroaryl group).

The term "R₁₀ₐ" as used herein refers to:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each being unsubstituted or substituted with deuterium, -F, -Cl, -Br, - I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each being unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), - B(Q₂₁)(Q₂₂), -C(=O)(Q₂₁), -S(=O)₂(Q₂₁), -P(=O)(Q₂₁)(Q₂₂), or any combination thereof; or

-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂).

Q₁₁ to Q₁₃, Q₂₁ to Q₂₃, and Q₃₁ to Q₃₃ as used herein may each independently be: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; a C₃-C₆₀ carbocyclic group or a C₁-C₆₀ heterocyclic group, each being unsubstituted or substituted with deuterium, -F, a cyano group, a C₁-C₆₀ alkyl group, a C₁-C₆₀ alkoxy group, a phenyl group, a biphenyl group, or any combination thereof; a C₇-C₆₀ arylalkyl group; or a C₂-C₆₀ heteroarylalkyl group.

The term "heteroatom" as used herein refers to any atom other than a carbon atom or a hydrogen atom. Examples of the heteroatom may be O, S, N, P, Si, B, Ge, Se, or any combination thereof.

The term "transition metal" used herein includes hafnium (Hf), tantalum (Ta), tungsten (W), rhenium (Re), osmium (Os), iridium (Ir), platinum (Pt), gold (Au), and/or the like.

The term "Ph" as used herein refers to a phenyl group, the term "Me" as used herein refers to a methyl group, the term "Et" as used herein refers to an ethyl group, the term "ter-Bu" or "Bu^{t}" as used herein refers to a tert-butyl group, and the term "OMe" as used herein refers to a methoxy group.

The term "biphenyl group" as used herein refers to "a phenyl group substituted with a phenyl group." For example, the "biphenyl group" is a substituted phenyl group having a C₆-C₆₀ aryl group as a substituent.

The term "terphenyl group" as used herein refers to "a phenyl group substituted with a biphenyl group". For example, the "terphenyl group" is a substituted phenyl group having, as a substituent, a C₆-C₆₀ aryl group substituted with a C₆-C₆₀ aryl group.
* and *' as used herein, unless defined otherwise, each refer to a binding site to a neighboring atom in a corresponding formula or moiety.

The terms "x-axis", "y-axis", and "z-axis" as used herein are not limited to three axes in an orthogonal coordinate system, and may be interpreted in a broader sense than the aforementioned three axes in an orthogonal coordinate system. For example, the x-axis, y-axis, and z-axis may describe axes that are orthogonal to each other, or may describe axes that are in different directions that are not orthogonal to each other.

As used herein, the term "C₃-C₆₀ carbocyclic group" includes a C₃-C₅₀ carbocyclic group, a C₃-C₄₀ carbocyclic group, a C₃-C₃₀ carbocyclic group, a C₃-C₂₀ carbocyclic group, or a C₃-C₁₀ carbocyclic group;
The term "C₁-C₆₀ heterocyclic group" includes a C₁-C₅₀ heterocyclic group, a C₁-C₄₀ heterocyclic group, a C₁-C₃₀ heterocyclic group, a C₁-C₂₀ heterocyclic group, or a C₁-C₁₀ heterocyclic group;
The term "C₁-C₆₀ alkyl group" includes a C₁-C₅₀ alkyl group, a C₁-C₃₀ alkyl group, a C₁-C₂₀ alkyl group, or a C₁-C₁₀ alkyl group;
The term "C₂-C₆₀ alkenyl group" includes a C₂-C₃₀ alkenyl group, a C₂-C₂₀ alkenyl group, or a C₂-C₁₀ alkenyl group;
The term "C₂-C₆₀ alkynyl group" includes a C₂-C₃₀ alkynyl group, a C₂-C₂₀ alkynyl group, or a C₂-C₁₀ alkynyl group;
The term "C₁-C₆₀ alkoxy group" includes a C₁-C₃₀ alkoxy group, a C₁-C₂₀ alkoxy group, or a C₁-C₁₀ alkoxy group;
The term "C₆-C₆₀ aryl group" includes a C₆-C₅₀ aryl group, a C₆-C₄₀ aryl group, a C₆-C₃₀ aryl group, a C₆-C₂₀ aryl group, or a C₆-C₁₅ aryl group;
The term "C₁-C₆₀ heteroaryl group" includes a C₁-C₅₀ heteroaryl group, a C₁-C₄₀ heteroaryl group, a C₁-C₃₀ heteroaryl group, a C₁-C₂₀ heteroaryl group, or a C₁-C₁₀ heteroaryl group;
The term "monovalent non-aromatic condensed polycyclic group" includes a C₈-C₆₀ monovalent non-aromatic condensed polycyclic group, a C₈-C₅₀ monovalent non-aromatic condensed polycyclic group, a C₈-C₄₀ monovalent non-aromatic condensed polycyclic group, a C₈-C₃₀ monovalent non-aromatic condensed polycyclic group, or a C₈-C₂₀ monovalent non-aromatic condensed polycyclic group;
The term "monovalent non-aromatic condensed heteropolycyclic group" includes a C₁-C₆₀ monovalent non-aromatic condensed heteropolycyclic group, a C₁-C₅₀ monovalent non-aromatic condensed heteropolycyclic group, a C₁-C₄₀ monovalent non-aromatic condensed heteropolycyclic group, a C₁-C₃₀ monovalent non-aromatic condensed heteropolycyclic group, or a C₁-C₂₀ monovalent non-aromatic condensed heteropolycyclic group;
The term "C₆-C₆₀ aryloxy group" includes a C₆-C₅₀ aryloxy group, a C₆-C₄₀ aryloxy group, a C₆-C₃₀ aryloxy group, a C₆-C₂₀ aryloxy group, or a C₆-C₁₅ aryloxy group;
The term "C₆-C₆₀ arylthio group" includes a C₆-C₅₀ arylthio group, a C₆-C₄₀ arylthio group, a C₆-C₃₀ arylthio group, a C₆-C₂₀ arylthio group, or a C₆-C₁₅ arylthio group;
The term "C₇-C₆₀ arylalkyl group" includes a C₇-C₅₀ arylalkyl group, a C₇-C₄₀ arylalkyl group, a C₇-C₃₀ arylalkyl group, a C₇-C₂₀ arylalkyl group, or a C₇-C₁₅ arylalkyl group; and
The term "C₂-C₆₀ heteroarylalkyl group" includes a C₂-C₅₀ heteroarylalkyl group, a C₂-C₄₀ heteroarylalkyl group, a C₂-C₃₀ heteroarylalkyl group, a C₂-C₂₀ heteroarylalkyl group, or a C₂-C₁₅ heteroarylalkyl group.
   In the present invention, "an integer selected from 0 to 20" refers to an integer selected from 0, 1, 2, 3, 4, 5, 6, 7, 8, 9, 10, 11, 12, 13, 14, 15, 16, 17, 18, 19, and 20. The above description of numerical ranges is also applicable for any other numerical range that appears in the present specification, for example, an integer selected from 0 and 1, an integer selected from 0 to 2, an integer selected from 0 to 3, an integer selected from 0 to 4, an integer selected from 0 to 5, an integer selected from 0 to 6, an integer selected from 0 to 7, an integer selected from 0 to 8, an integer selected from 0 to 9, an integer selected from 0 to 10, an integer selected from 0 to 11, an integer selected from 0 to 12, an integer selected from 0 to 13, an integer selected from 0 to 14, an integer selected from 0 to 15, an integer selected from 0 to 16, an integer selected from 0 to 17, an integer selected from 0 to 18, an integer selected from 0 to 19, and the like.

Hereinafter, a metal oxide composition and a light-emitting device according to one or more embodiments will be described in more detail with reference to the following Examples.

### Examples

### Synthesis Example 1

### Synthesis of ZnMgO nanoparticles

For the synthesis of ZnMgO nanoparticles, 65.2 mmol of zinc acetate, 14.8 mmol of magnesium acetate, and 320 mL of dimethyl sulfoxide were injected into a reactor under a nitrogen atmosphere and stirred at room temperature for 120 minutes. Next, the temperature of the reactor was lowered to 4 °C, and 80 mL of a mixed solution of 1M tetramethylammonium hydroxide (TMAH) and ethanol was injected for 20 minutes. After the injection of mixed solution of TMAH was completed, the reaction was maintained for 2 hours and then the synthesized ZnMgO nanoparticles were precipitated using acetone and hexane. The final precipitated ZnMgO nanoparticles were dispersed in ethanol.

### Purification of ZnMgO nanoparticles

The ZnMgO nanoparticle dispersion in ethanol was centrifuged at 12,000 rpm for 10 minutes to remove undispersed matter. Afterwards, hexane was injected in excess to precipitate ZnMgO nanoparticles. ZnMgO nanoparticles were obtained by centrifuging the hexane solution in which ZnMgO nanoparticles were precipitated. This process was repeated once more to purify ZnMgO nanoparticles. ZnMgO nanoparticles, after the purification process, were dispersed in 2-(2-tertbutoxyethoxy)ethanol solvent at 2 wt% based on the weight (e.g., based on 100 wt%) of the solvent to prepare a ZnMgO nanoparticle dispersion.

### Preparation of LiCl solution

LiCl was injected into 2-(2-tert-butoxyethoxy)ethanol solvent at a concentration of 25 mg/mL, stirred at room temperature for 10 minutes, then heated to 80 °C and stirred for an additional hour, after which the solution was cooled to room temperature to prepare the LiCl solution.

### Test Example 1 (Preparation of ZnMgO Nanoparticle Composition)

The LiCl solution was injected into the ZnMgO nanoparticle dispersion prepared in Synthesis Example 1 and stirred at room temperature for 30 minutes to prepare a ZnMgO nanoparticle composition. The concentration of LiCl was 1 wt% with respect to the weight of ZnMgO nanoparticles.

### Test Examples 2 to 4

The ZnMgO nanoparticle compositions were prepared using substantially the same method as in Test Example 1, except that LiCl or LiBr at the concentrations listed in Table 1 was used instead of 1 wt% LiCl.

### Test Examples 5 to 10

The ZnMgO nanoparticle compositions were prepared using substantially the same method as in Test Example 1, except that the metal halide at the concentration listed in Table 1 was used instead of 1 wt% LiCl.

### Comparative Test Example 1

A ZnMgO nanoparticle composition was prepared using substantially the same method as Test Example 1, except that no additives were used in the ZnMgO nanoparticle dispersion that was synthesized according to Synthesis Example 1 but not subjected to the purification process.

### Comparative Test Example 2

A ZnMgO nanoparticle composition was prepared using substantially the same method as in Test Example 1, except that no additive was used in the ZnMgO nanoparticle dispersion synthesized and purified according to Synthesis Example 1.

### Comparative Test Example 3

A ZnMgO nanoparticle composition was prepared using substantially the same method as Test Example 2, except that a ZnMgO nanoparticle dispersion was prepared according to Synthesis Example 1 and had not undergone a purification process.

### Comparative Test Example 4

A ZnMgO composition was prepared using substantially the same method as in Test Example 1, except that 7 wt% LiCl was used instead of 1 wt% LiCl.

### Comparative Test Example 5

A ZnMgO composition was prepared using substantially the same method as in Test Example 1, except that 7 wt% ZnCl₂ was used instead of 1 wt% LiCl.

### Evaluation Example 1

The surface organic content and average particle size of the ZnMgO nanoparticles used in the ZnMgO nanoparticle compositions of Test Examples 1 to 10 and Comparative Test Examples 1 to 5 and the photoluminescence efficiency of the compositions were measured. Results thereof are shown in Table 1. The reduction ratio of the photoluminescence of the ZnMgO nanoparticle layer/quantum dot layer double film with respect to the photoluminescence of the quantum dot layer single film is shown in Table 1. The ZnMgO nanoparticle layer was formed or provided from the ZnMgO nanoparticle compositions of Test Examples 1 to 10 and Comparative Test Examples 1 to 5. In one or more embodiments, the current efficiency and lifespan (T90) when the ZnMgO nanoparticle compositions of Test Examples 1 to 10 and Comparative Test Examples 1 to 5 were applied to the electron transport layer of the light-emitting device are shown in Table 2.

### Surface organic content of ZnMgO nanoparticles

The surface organic content of the ZnMgO nanoparticles used in the compositions of Test Examples 1 to 10 and Comparative Test Examples 1 to 5 was measured by utilizing a thermogravimetric (TGA) analyzer (SDT650, TA Instruments). The results are shown in Table 1. Referring to Table 1, the surface organic content of the ZnMgO nanoparticles of the compositions of Test Examples 1 to 10 and Comparative Test Examples 2, 4 and 5 was about 19 to about 20 wt%, whereas the surface organic content of the ZnMgO nanoparticles of the compositions of Comparative Test Examples 1 and 3 was about 23 wt%, which was higher than that of Test Examples 1 to 10 and Comparative Test Examples 2, 4 and 5. This demonstrates that organic materials present on the particle surface were more efficiently removed from the refined ZnMgO nanoparticles used in Test Examples 1 to 10 and Comparative Test Examples 2, 4 and 5, as compared to the unrefined ZnMgO nanoparticles used in Comparative Test Examples 1 and 3.

### Photoluminescence efficiency of ZnMgO nanoparticle composition

The photoluminescence quantum efficiency of each of the compositions of Test Examples 1 to 10 and Comparative Test Examples 1 to 5 was measured using QE-2100 equipment (Otsuka). Results thereof are shown in Table 1. The excitation wavelength was 330 nm, and the emission wavelength range used for quantum efficiency measurement was 370 nm to 750 nm. Although the present disclosure is not bound by any particular mechanism or theory, the photoluminescence of ZnMgO nanoparticles is considered to be due to defects present on the surface and inside of ZnMgO nanoparticles. Referring to Table 1, the photoluminescence quantum efficiency of each of the compositions of Test Examples 1 to 10 and Comparative Test Examples 4 and 5 is 33% or 34%, the photoluminescence quantum efficiency of each of the compositions of Comparative Test Examples 1 and 2 is 48%, and the photoluminescence quantum efficiency of the composition of Comparative Test Example 3 is 40%. Although the present disclosure is not bound by any particular mechanism or theory, the feature in which the photoluminescence quantum efficiency of each of the compositions of Test Examples 1 to 10 and Comparative Test Examples 4 and 5 is lower than that of the compositions of Comparative Test Examples 1 to 3, is considered to be due to the reduction in defects in the ZnMgO nanoparticles caused by the addition of metal halides. This effect may also be confirmed by the lower photoluminescence quantum efficiency of the composition of Comparative Test Example 3 compared to the photoluminescence quantum efficiency of the compositions of Comparative Test Examples 1 and 2.

### Average particle size of ZnMgO nanoparticles

The particle size analysis by dynamic light scattering (DLS) was performed on the ZnMgO nanoparticle compositions of Test Examples 1 to 10 and Comparative Test Examples 1 to 5 by using Nano-ZS90, which is the product of Malvern Inc. The average particle sizes of ZnMgO nanoparticles on day 0 and day 14 were measured. The results are shown in Table 1. Referring to Table 1, the difference in the average particle size of the ZnMgO nanoparticles on day 0 and day 14 of the compositions of Test Examples 1 to 10 was within the range of ±1.0 nm, showing that the change in the particles in the composition over time was not significant and was stable. In contrast, the compositions of Comparative Test Examples 1 and 2 had a difference in the average particle size of ZnMgO nanoparticles of ±1.4 nm or more on day 0 and day 14. In one or more embodiments, in the case of Comparative Test Examples 4 and 5 in which the amount of metal halide was injected at 7 wt% or more, the difference in the average particle size of ZnMgO nanoparticles on day 0 and day 14 increased by at least twice, and it may be seen that such a change over time may induce agglomeration of ZnMgO nanoparticles, which may induce nozzle clogging during inkjet ejection, making it unsuitable as ink for inkjet.

### Photoluminescence of blue ZnSeTe quantum dot layer/ZnMgO nanoparticle layer

A blue ZnSeTe quantum dot layer having a thickness of 400 Å was formed or provided on a glass substrate by a spin coating process. The ZnMgO nanoparticle composition manufactured in Test Example 1 was formed or provided to a thickness of 360 Å on the blue ZnSeTe quantum dot layer using substantially the same spin coating process as described in one or more embodiments to produce a double thin film (a QD/ZnMgO thin film) of a blue ZnSeTe quantum dot layer/ZnMgO nanoparticle layer. For the double thin films, photoluminescence was measured by using a photoluminescence measuring device (FluoroMax Plus). In one or more embodiments, photoluminescence was measured for a blue ZnSeTe quantum dot layer single film (QD film) having a thickness of 400 Å formed or provided on a glass substrate by a spin coating process. The wavelength of the irradiation light was 370 nm, and the measurement wavelength range was 410 nm to 780 nm. The photoluminescence reduction ratio of the quantum dot layer/ZnMgO nanoparticle layer double thin films compared to the blue ZnSeTe quantum dot layer single thin film is shown in Table 1. The photoluminescence reduction ratio was obtained by calculating the difference between the photoluminescence intensity of the blue ZnSeTe quantum dot layer single film and the photoluminescence intensity of the blue ZnSeTe quantum dot layer/ZnMgO nanoparticle layer double film, and dividing this difference by the photoluminescence intensity of the blue ZnSeTe quantum dot layer single film. The smaller the photoluminescence reduction ratio is, the more the non-luminescence processes due to defects in the ZnMgO nanoparticle layer is suppressed or reduced. When the compositions of Test Examples 1 to 10 were used, a small photoluminescence reduction ratio of about -4% to -6% was observed, but when the compositions of Comparative Test Examples 1 to 3 were used, a large photoluminescence reduction ratio of about -20% to -33% was observed. This demonstrates that the purification of ZnMgO particles and the addition of metal halides may effectively or suitably suppress or reduce the non-luminescence processes. For Comparative Test Examples 4 and 5, the photoluminescence reduction ratio is similar to that of Test Examples 1 to 9, but as described in one or more embodiments, the difference in the average particle size on day 0 and day 14 is large, and thus, the compositions of Comparative Test Examples 4 and 5 seem to be unsuitable for the inkjet process.

**Table 1**

| | ZnMgO nanoparticl es Surface organic content (wt%) | Additiv es | Additiv e conten t (wt%) | ZnMgO Photolum inescenc e Quantum efficiency (%) | Average particle size (nm) | | QD/ZnMgO thin film |
|---|---|---|---|---|---|---|---|
| | | | | | Day 0 | Day 14 | QD thin film comparison Photolumin escence reduction ratio |
| Test Example 1 | 19.2 | LiCl | 1 | 34 | 11.0 | 11.8 | -4% |
| Test Example 2 | 19.4 | LiCl | 2 | 34 | 10.6 | 11.2 | -4% |
| Test Example 3 | 19.2 | LiCl | 5 | 33 | 11.0 | 12.0 | -4% |
| Test Example 4 | 19.5 | LiBr | 2 | 33 | 11.0 | 11.3 | -4% |
| Test Example 5 | 19.2 | ZnCl₂ | 2 | 34 | 11.0 | 11.8 | -4% |
| Test Example 6 | 19.4 | ZnCl₂ | 5 | 34 | 10.6 | 11.2 | -4% |
| Test Example 7 | 19.3 | ZnBr₂ | 2 | 33 | 10.8 | 11.3 | -4% |
| Test Example 8 | 19.3 | ZnI₂ | 2 | 33 | 11.0 | 11.2 | -4% |
| Test Example 9 | 19.5 | MgCl₂ | 2 | 34 | 10.2 | 10.5 | -5% |
| Test Example 10 | 19.5 | GaCl₂ | 2 | 34 | 10.9 | 11.1 | -6% |
| Compara tive Test Example 1 | 23.1 | - | - | 48 | 12.7 | 11.3 | -33% |
| Compara tive Test Example 2 | 20.1 | - | - | 48 | 12.7 | 11.3 | -33% |
| Compara tive Test Example 3 | 23.0 | LiCl | 2 | 40 | 11.6 | 11.2 | -20% |
| Compara tive Test Example 4 | 19.3 | LiCl | 7 | 33 | 11.0 | 22.2 | -4% |
| Compara tive Test Example 5 | 19.3 | ZnCl₂ | 7 | 33 | 11.0 | 22.2 | -4% |

### Examples 1 to 10 (Manufacture of light-emitting devices)

As an anode, a glass substrate (manufactured by Corning) having an ITO electrode of 15 Ω/cm² (1200 Å) was cut to a size of 50 mm x 50 mm x 0.5 mm, ultrasonically cleaned with isopropyl alcohol and pure water for 5 minutes each, and then cleaned by ultraviolet (UV) irradiation and ozone exposure for 30 minutes.

On the anode, PEDOT:PSS (Clevios^{™}) was spin-coated to form or provide a film having a thickness of 1000 Å, followed by baking at 120 °C for 10 minutes to form or provide a hole injection layer. TFB was spin-coated on the hole injection layer to form or provide a film having a thickness of 200 Å, followed by baking at 120 °C for 10 minutes to form or provide a hole transport layer.

On the hole transport layer, blue-emitting ZnSeTe quantum dots dispersed in octane were inkjet-printed to form or provide a film having a thickness of 400 Å, followed by baking at 100 °C for 10 minutes to form or provide an emission layer. On the emission layer, the ZnMgO nanoparticle compositions of Test Examples 1 to 10 as described in Table 2 were inkjet-printed to form or provide a film having a thickness of 360 Å, followed by baking at 120 °C for 10 minutes to form or provide an electron transport layer. AgMg (Ag:Mg weight ratio (10:1)) was deposited on the electron transport layer to form or provide a cathode having a thickness of 200 Å, thereby completing the manufacture of a light-emitting device.

### Comparative Examples 1 to 5

The light-emitting devices were manufactured in substantially the same manner as in Example 1, except that the ZnMgO nanoparticle compositions of Comparative Test Examples 1 to 5, as described in Table 2, were used instead of the ZnMgO nanoparticle composition of Test Example 1 when forming or providing the electron transport layer.

### Evaluation Example 2

The current efficiency (cd/A) and device lifespan (T90) at 146 nit brightness of the light-emitting devices manufactured in Examples 1 to 10 and Comparative Examples 1 to 5 were measured by using a Keithley SMU 236 and a luminance meter PR650, respectively. The results are shown in Table 2. In Table 2, the device lifespan (T90) is the time (h) required for the brightness to reach 90% of the initial brightness.

**Table 2**

| | ZnMgO nanoparticle Composition for Electron transport layer | Efficiency (cd/A) | T90 (hr) |
|---|---|---|---|
| Example 1 | Test Example 1 | 147.4 | 250 |
| Example 2 | Test Example 2 | 112.7 | 900 |
| Example 3 | Test Example 3 | 114.5 | 400 |
| Example 4 | Test Example 4 | 110.5 | 180 |
| Example 5 | Test Example 5 | 147.4 | 250 |
| Example 6 | Test Example 6 | 122.7 | 912 |
| Example 7 | Test Example 7 | 125.2 | 200 |
| Example 8 | Test Example 8 | 110.5 | 180 |
| Example 9 | Test Example 9 | 133.8 | 300 |
| Example 10 | Test Example 10 | 110.3 | 182 |
| Comparative Example 1 | Comparative Test Example 1 | 73.0 | 14 |
| Comparative Example 2 | Comparative Test Example 2 | 91.1 | 90 |
| Comparative Example 3 | Comparative Test Example 3 | 80.2 | 80 |
| Comparative Example 4 | Comparative Test Example 4 | 125.2 | 200 |
| Comparative Example 5 | Comparative Test Example 5 | 89.2 | 90 |

Referring to Table 2, it can be seen that the light-emitting devices of Examples 1 to 10 show higher current efficiency and longer lifespan compared to Comparative Examples 1 to 3 and Comparative Example 5. The light-emitting devices of Comparative Examples 1 and 2 do not include a metal halide additive in the ZnMgO nanoparticle composition used in an electron transport layer. In the case of the light-emitting device of Comparative Example 3, a ZnMgO nanoparticle composition used in the electron transport layer includes a metal halide additive, but the surface organic content of the ZnMgO nanoparticles is high. In the case of the light-emitting device of Comparative Example 5, because the amount of ZnCl₂ used as an additive in the ZnMgO nanoparticle composition used in the electron transport layer is high, agglomeration occurs in the composition and an uneven film is formed, resulting in a deterioration in the device characteristics. In the case of light-emitting device of Comparative Example 4, efficiency and lifespan were high. However, because the average particle size of the ZnMgO nanoparticle composition of Comparative Test Example 4 used to form or provide the ZnMgO thin film changes significantly over time, it is expected that as in Comparative Example 5, the efficiency and lifespan of the light-emitting device will deteriorate due to deterioration of film characteristics if (e.g., when) operating the process for a long time.

The metal oxide compositions according to one or more embodiments may have reduced defects (e.g., a degree or occurrence of defects) in metal oxide nanoparticle and increased or enhanced stability (e.g., physical stability and/or structural stability). In one or more embodiments, the light-emitting device according to one or more embodiments may have improved or enhanced luminescence efficiency and lifespan.

It should be understood that embodiments described herein should be considered in a descriptive sense only and not for purposes of limitation. Descriptions of features or aspects within each embodiment should typically be considered as available for other similar features or aspects in other embodiments. While the subject matter of the present disclosure has been described with reference to the figures, it will be understood by those of ordinary skill in the art that one or more suitable changes in form and more details may be made therein without departing from the scope as defined by the following claims and equivalents thereof.

## Claims

1. A metal oxide composition comprising:
a metal oxide nanoparticle (1);
a metal halide; and
a solvent, wherein
an amount of an organic material (2) on the surface of the metal oxide nanoparticle (1) is in a range of about 12 wt% to about 21 wt% based on 100 wt% of the metal oxide nanoparticle (1), and
an amount of the metal halide is greater than 0 wt% but not more than about 7.0 wt% based on 100 wt% of the metal oxide nanoparticle.

2. The metal oxide composition as claimed in claim 1, wherein
the metal oxide nanoparticle (1) is represented by Formula 1:
Formula 1 M¹₁₋ₓM²ₓO_{y}
wherein, in Formula 1,
M¹ and M² each independently comprise Zn, Mg, Co, Mn, Y, Al, Ti, Zr, Sn, W, Ta, Ni, Mo, Cu, Ag, In, Nb, Fe, Ce, Sr, Ba, Si, Ga, or a combination thereof, and
0≤x≤1 and 0<y≤5.

3. The metal oxide composition as claimed in claim 2, wherein
M¹ is Zn and 0≤x≤0.5.

4. The metal oxide composition as claimed in claim 2, wherein
M¹ is Zn, M² is Mg, and 0<x≤0.5.

5. The metal oxide composition as claimed in any one of claims 1 to 4, wherein
the metal halide is represented by Formula 2:
Formula 2 M³(X¹)_{z}
wherein, in Formula 2,
M³ is an alkali metal, an alkaline earth metal, or a transition metal,
X¹ is F, Cl, Br, or I, and
z is an integer of 1 to 3.

6. The metal oxide composition as claimed in claim 5, wherein:
(i) M³ is Li, Na, K, Rb, Cs, Mg, Zn, In, Ti, Ga, or any combination thereof; or
(ii) the metal halide comprises LiCl, LiBr, ZnCl₂, ZnBr₂, Znl₂, MgCl₂, GaCl₂, or a combination thereof.

7. The metal oxide composition as claimed in any one of claims 1 to 6, wherein
an amount of the metal oxide nanoparticle (1) is in a range of about 0.5 wt% to about 10 wt% based on 100 wt% of the metal oxide composition.

8. The metal oxide composition as claimed in any one of claims 1 to 7, wherein
an amount of the metal halide is in a range of about 0.1 wt% to about 7.0 wt% based on 100 wt% of the metal oxide nanoparticle (1).

9. The metal oxide composition as claimed in any one of claims 1 to 8, wherein
the solvent comprises at least one selected from among ethanol, methanol, 2-(2-tertbutoxyethoxy)ethanol, 2-(2-(2-tertbutoxyethoxy)ethoxy)ethanol, 2-(2-(2-isopropoxyethoxy)ethoxy)ethanol, 2-(2-(isopentyloxy)ethoxy)ethanol, 2-(2-(benzyloxy)ethoxy)ethanol, 2-(2-(2-(benzyloxy)ethoxy)ethoxy)ethanol, and 2-((tetrahydrofuran-2-yl)methoxy)ethanol.

10. A light-emitting device (10) comprising: a first electrode (110); a second electrode (150) opposite to the first electrode (110); and an interlayer (130) between the first electrode (110) and the second electrode (150), wherein
the interlayer (130) comprises an emission layer and an electron transport region between the emission layer and the second electrode (150), and
the electron transport region comprises an electron transport layer provided from the metal oxide composition as claimed in any one of claims 1 to 9.

11. The light-emitting device (10) as claimed in claim 10, wherein:
(i) the electron transport region further comprises a hole-blocking layer, an electron injection layer, or any combination thereof; and/or
(ii) the interlayer further comprises a hole transport region between the first electrode (110) and the emission layer, and the hole transport region comprises a hole injection layer, a hole transport layer, an emission auxiliary layer, an electron-blocking layer, or any combination thereof.

12. The light-emitting device (10) as claimed in claim 10 or claim 11, wherein
the emission layer comprises quantum dots, optionally wherein
the quantum dots comprise a Group II-VI semiconductor compound, a Group III-V semiconductor compound, a Group III-VI semiconductor compound, a Group I-III-VI semiconductor compound, a Group IV-VI semiconductor compound, a Group IV element or compound, or a combination thereof.

13. An electronic apparatus, comprising the light-emitting device (10) as claimed in any one of claims 10 to 12.

14. The electronic apparatus as claimed in claim 13, further comprising:
(i) a thin-film transistor, wherein
the thin-film transistor comprises a source electrode (260) and a drain electrode (270), and
the first electrode (110) of the light-emitting device (10) is electrically connected to at least one selected from the source electrode (260) and the drain electrode (270) of the thin-film transistor; and/or
(ii) a color filter, a color conversion layer, a touch screen layer, a polarizing layer, or any combination thereof.

15. An electronic device (1) comprising the light-emitting device (10) as claimed in any one of claims 10 to 12, optionally wherein
the electronic device (1) is one selected from among a flat panel display, a curved display, a computer monitor, a medical monitor, a television, a billboard, an indoor light, an outdoor light, a light for signal, a head-up display, a fully transparent display, a partially transparent display, a flexible display, a rollable display, a foldable display, a stretchable display, a laser printer, a telephone, a portable phone, a tablet personal computer, a phablet, a personal digital assistant (PDA), a wearable device, a laptop computer, a digital camera, a camcorder, a viewfinder, a micro display, a three-dimensional (3D) display, a virtual reality display, an augmented reality display, a vehicle, a video wall comprising a plurality of displays tiled together, a theater screen, a stadium screen, a phototherapy device, and a signboard.
